# EUROPEAN PATENT APPLICATION

(11) **EP 4 657 158 A1**
(43) Date of publication of application: **03.12.2025**
(21) Application number: 24763810.9
(22) Date of filing: 26.02.2024
(51) Int. Cl.: G03F 7/11, C08G 59/48, C08G 59/50, G03F 7/26, H01L 21/027

(54) **RESIST UNDERLAYER FILM FORMATION COMPOSITION**

(30) Priority: 27.02.2023 JP 2023028213
(71) Applicant: Nissan Chemical Corporation, Tokyo 103-6119 (JP)
(72) Inventor: MIZUOCHI, Ryuta, Toyama-shi, Toyama 939-2792 (JP); IGATA, Kosuke, Toyama-shi, Toyama 939-2792 (JP); TAMURA, Mamoru, Toyama-shi, Toyama 939-2792 (JP)
(74) Representative: Müller-Boré & Partner Patentanwälte PartG mbB
(86) International application number: PCT/JP2024/006699
(87) International publication number: WO 2024/181330

(57) **Abstract**

A resist underlayer film-forming composition, containing a polymer (A) having a repeating unit represented by formula (1) below and a solvent (B).

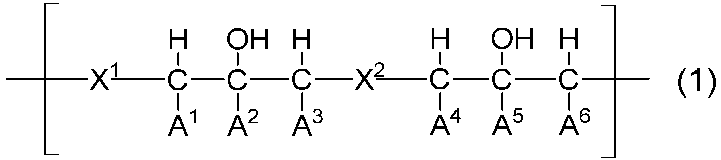

In formula (1), X¹ represents a divalent group having a ring structure and an iodine atom directly bonded to the ring structure,
X² represents a divalent group, and
A¹, A², A³, A⁴, A⁵, and A⁶ each independently represent a hydrogen atom, a methyl group, or an ethyl group.

## Description

### Technical Field

The present invention relates to a resist underlayer film-forming composition, a resist underlayer film, a laminate, a semiconductor element producing method, and a pattern forming method.

### Background Art

Conventionally, microfabrication by lithography using a resist composition has been performed in the production of a semiconductor device. The microfabrication is a processing method of forming microrelief corresponding to a photoresist pattern on a substrate surface by forming a thin film of a photoresist composition on a semiconductor substrate such as a silicon wafer, irradiating the thin film with an active ray such as an ultraviolet ray through a mask pattern on which a device pattern is drawn, developing the thin film, and etching the substrate using the obtained photoresist pattern as a protective film. In recent years, the degree of integration of a semiconductor device has been increased, and as an active ray to be used, EUV light (wavelength: 13.5 nm) or an electron beam (EB) has been studied to be put into practical use for the most advanced microfabrication, in addition to an i-line (wavelength: 365 nm), a KrF excimer laser (wavelength: 248 nm), and an ArF excimer laser (wavelength: 193 nm) which have conventionally been used. At the same time, defects in the formation of the resist pattern due to an influence of the semiconductor substrate and the like are a big problem. Therefore, in order to solve this problem, a method of providing a resist underlayer film between a resist and a semiconductor substrate has been widely studied.

Patent Literature 1 discloses an antireflection film-forming composition containing a polymer having a specific structure. Patent Literature 2 discloses an underlayer coating composition containing a polymer including a repeating unit derived from a specific monomer and a crosslinking agent.

### Citation List

### Patent Literature

Patent Literature 1: WO 2005/098542 A
Patent Literature 2: JP 2020-76081 A

### Summary of Invention

### Technical Problem

Examples of the properties required for the resist underlayer film include that a resist pattern can be formed with high sensitivity and that the etching rate is high.

The present invention has been made in view of the above circumstances, and an object of the present invention is to provide a resist underlayer film-forming composition capable of forming a resist underlayer film which has a high etching rate without deteriorating lithographic properties, and a resist underlayer film, a laminate, a semiconductor element producing method, and a pattern forming method using the resist underlayer film-forming composition.

### Solution to Problem

As a result of intensive studies to solve the above problem, the present inventors have found that the above problem can be solved and have completed the present invention having the following gist.

That is, the present invention includes the following aspects.
[1] A resist underlayer film-forming composition, containing a polymer (A) having a repeating unit represented by formula (1) below and a solvent (B): 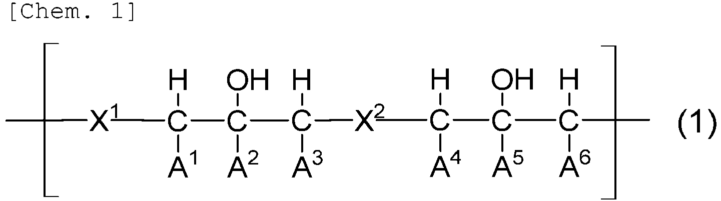
   in formula (1), X¹ represents a divalent group having a ring structure and an iodine atom directly bonded to the ring structure,
   X² represents a divalent group, and
   A¹, A², A³, A⁴, A⁵, and A⁶ each independently represent a hydrogen atom, a methyl group, or an ethyl group.
[2] The resist underlayer film-forming composition according to [1], wherein X¹ in formula (1) represents any of a group represented by formula (2-1) below, a group represented by formula (2-2) below, and a group represented by formula (2-3) below: 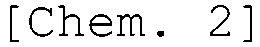 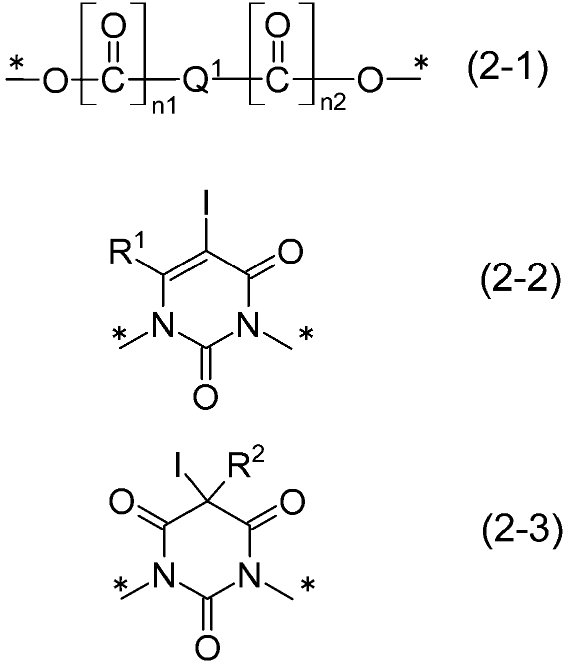
   in formula (2-1), Q¹ represents a divalent organic group represented by formula (2-1-1) below, a divalent organic group represented by formula (2-1-2) below, a divalent organic group represented by formula (2-1-3) below, or a divalent organic group represented by formula (2-1-4) below, n1 and n2 each independently represent 0 or 1, and * represents a bond,
   in formula (2-2), R¹ represents a hydrogen atom, a halogen atom, or an organic group having 1 to 10 carbon atoms, and * represents a bond,
   in formula (2-3), R² represents a hydrogen atom, a halogen atom, or an organic group having 1 to 10 carbon atoms, and * represents a bond: 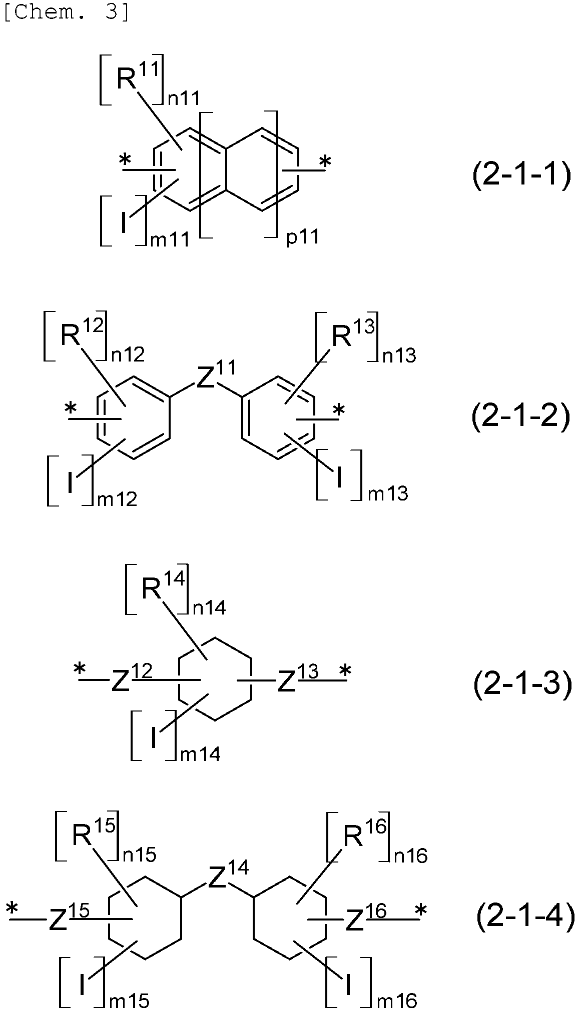
   in formulae (2-1-1) to (2-1-4), R¹¹ to R¹⁶ each independently represent a halogen atom (exclusive of an iodine atom), a hydroxy group, a cyano group, an alkyl group having 1 to 6 carbon atoms, an alkenyl group having 2 to 6 carbon atoms, an alkynyl group having 2 to 6 carbon atoms, an alkoxy group having 1 to 6 carbon atoms, an alkenyloxy group having 2 to 6 carbon atoms, an alkynyloxy group having 2 to 6 carbon atoms, an acyl group having 2 to 6 carbon atoms, an aryloxy group having 6 to 12 carbon atoms, an arylcarbonyl group having 7 to 13 carbon atoms, an aralkyl group having 7 to 13 carbon atoms, or -N(R^{a})(R^{b}) (R^{a} and R^{b} each independently represent a hydrogen atom or an alkyl group having 1 to 6 carbon atoms), and * represents a bond,
   in formula (2-1-1), p11 represents an integer of 0 to 2, when p11 is 0, m11 represents an integer of 1 to 4, n11 represents an integer of 0 to 3, and a sum of m11 and n11 is 4 or less, when p11 is 1, m11 represents an integer of 1 to 6, n11 represents an integer of 0 to 5, and a sum of m11 and n11 is 6 or less, when p11 is 2, m11 represents an integer of 1 to 8, n11 represents an integer of 0 to 7, and a sum of m11 and n11 is 8 or less, and when two or more R¹¹'s are present, the two or more R¹¹'s may be identical or different,
   in formula (2-1-2), Z¹¹ represents a single bond, an oxygen atom, a sulfur atom, a carbonyl group, a sulfonyl group, or an alkylene group having 1 to 6 carbon atoms, m12 and m13 each independently represent an integer of 0 to 4, n12 and n13 each independently represent an integer of 0 to 4, a sum of m12 and m13 is 1 or more, a sum of m12 and n12 is 4 or less, and a sum of m13 and n13 is 4 or less, when two or more R¹²'s are present, the two or more R¹²'s may be identical or different, and when two or more R¹³'s are present, the two or more R¹³'s may be identical or different,
   in formula (2-1-3), Z¹² and Z¹³ each independently represent a single bond or a linear or branched alkylene group having 1 to 6 carbon atoms, m14 represents an integer of 1 to 4, n14 represents an integer of 0 to 3, and a sum of m14 and n14 is 4 or less, and when two or more R¹⁴'s are present, the two or more R¹⁴'s may be identical or different,
   in formula (2-1-4), Z¹⁴ represents a single bond, an oxygen atom, a sulfur atom, a carbonyl group, a sulfonyl group, or an alkylene group having 1 to 6 carbon atoms, Z¹⁵ and Z¹⁶ each independently represent a single bond or a linear or branched alkylene group having 1 to 6 carbon atoms, m15 and m16 each independently represent an integer of 0 to 4, n15 and n16 each independently represent an integer of 0 to 4, a sum of m15 and m16 is 1 or more, a sum of m15 and n15 is 4 or less, and a sum of m16 and n16 is 4 or less, when two or more R¹⁵'s are present, the two or more R¹⁵'s may be identical or different, and when two or more R¹⁶'s are present, the two or more R¹⁶'s may be identical or different.
[3] The resist underlayer film-forming composition according to [1] or [2], wherein X² in formula (1) represents either a group represented by formula (3-1) below or a group represented by formula (3-2) below: 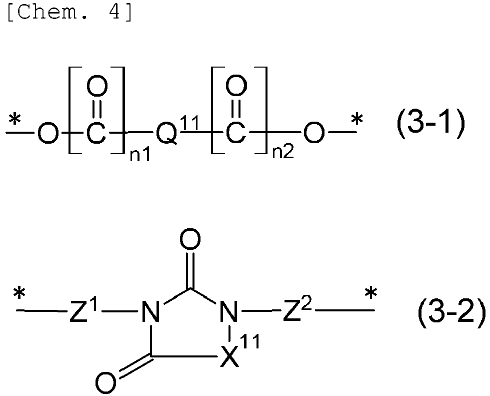
   in formula (3-1), Q¹¹ represents a divalent acyclic hydrocarbon group having 2 to 20 carbon atoms which may be interrupted by an oxygen atom, a divalent organic group represented by formula (3-1-1) below, a divalent organic group represented by formula (3-1-2) below, a divalent organic group represented by formula (3-1-3) below, or a divalent organic group represented by formula (3-1-4) below, n1 and n2 each independently represent 0 or 1, and * represents a bond,
   in formula (3-2), X¹¹ represents a divalent group represented by any of formulae (3-2-1) to (3-2-3) below, Z¹ and Z² each independently represent a single bond or a divalent group represented by formula (2-2-4) below, and * represents a bond: 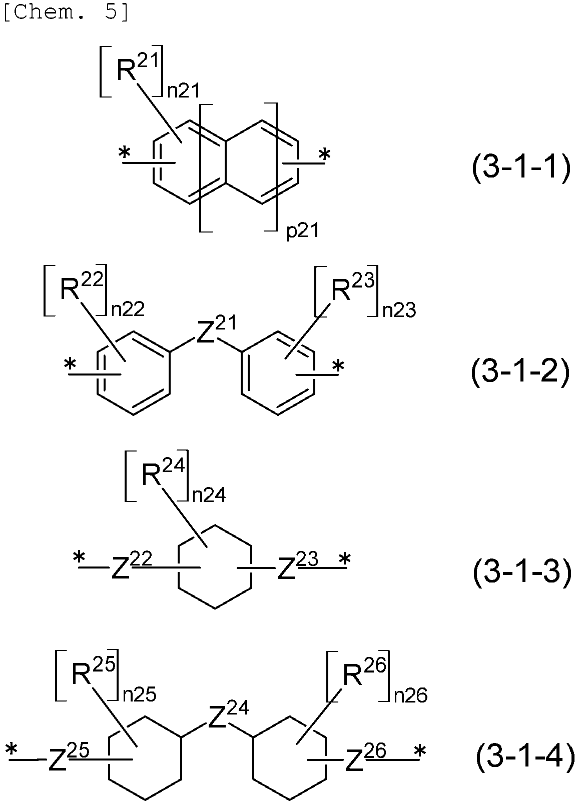
   in formulae (3-1-1) to (3-1-4), R²¹ to R²⁶ each independently represent a halogen atom, a hydroxy group, a cyano group, an alkyl group having 1 to 6 carbon atoms, an alkenyl group having 2 to 6 carbon atoms, an alkynyl group having 2 to 6 carbon atoms, an alkoxy group having 1 to 6 carbon atoms, an alkenyloxy group having 2 to 6 carbon atoms, an alkynyloxy group having 2 to 6 carbon atoms, an acyl group having 2 to 6 carbon atoms, an aryloxy group having 6 to 12 carbon atoms, an arylcarbonyl group having 7 to 13 carbon atoms, or an aralkyl group having 7 to 13 carbon atoms, and * represents a bond,
   in formula (3-1-1), p21 represents an integer of 0 to 2, when p21 is 0, n21 represents an integer of 0 to 4, when p21 is 1, n21 represents an integer of 0 to 6, when p21 is 2, n21 represents an integer of 0 to 8, and when two or more R²¹'s are present, the two or more R²¹'s may be identical or different,
   in formula (3-1-2), Z²¹ represents a single bond, an oxygen atom, a sulfur atom, a carbonyl group, a sulfonyl group, or an alkylene group having 1 to 6 carbon atoms, n22 and n23 each independently represent an integer of 0 to 4, when two or more R²²'s are present, the two or more R²²'s may be identical or different, and when two or more R²³'s are present, the two or more R²³'s may be identical or different,
   in formula (3-1-3), Z²² and Z²³ each independently represent a single bond or a linear or branched alkylene group having 1 to 6 carbon atoms, n24 represents an integer of 0 to 4, and when two or more R²⁴'s are present, the two or more R²⁴'s may be identical or different,
   in formula (3-1-4), Z²⁴ represents a single bond, an oxygen atom, a sulfur atom, a carbonyl group, a sulfonyl group, or an alkylene group having 1 to 6 carbon atoms, Z²⁵ and Z²⁶ each independently represent a single bond or a linear or branched alkylene group having 1 to 6 carbon atoms, n25 and n26 each independently represent an integer of 0 to 4, when two or more R²⁵'s are present, the two or more R²⁵'s may be identical or different, and when two or more R²⁶'s are present, the two or more R²⁶'s may be identical or different: 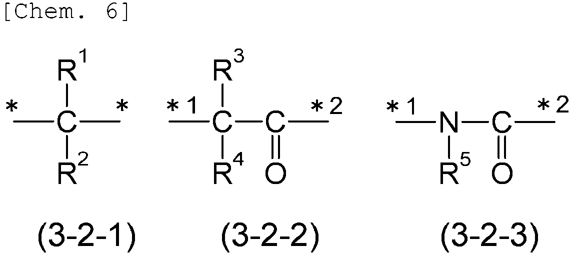
   in formulae (3-2-1) to (3-2-3), R¹ to R⁵ each independently represent a hydrogen atom, an alkyl group having 1 to 10 carbon atoms which may be interrupted by an oxygen atom or a sulfur atom, an alkenyl group having 2 to 10 carbon atoms which may be interrupted by an oxygen atom or a sulfur atom, an alkynyl group having 2 to 10 carbon atoms which may be interrupted by an oxygen atom or a sulfur atom, a benzyl group, or a phenyl group, wherein the phenyl group may be substituted with at least one monovalent group selected from a group consisting of an alkyl group having 1 to 6 carbon atoms, a halogen atom, an alkoxy group having 1 to 6 carbon atoms, a nitro group, a cyano group, and an alkylthio group having 1 to 6 carbon atoms, R¹ and R² may be bonded to each other to form a ring having 3 to 6 carbon atoms, and R³ and R⁴ may be bonded to each other to form a ring having 3 to 6 carbon atoms,
   * represents a bond, *1 represents a bond bonded to a carbon atom in formula (3-2), and *2 represents a bond bonded to a nitrogen atom in formula (3-2): 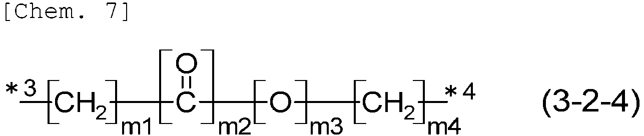
   in formula (3-2-4), m1 is an integer of 0 to 4, m2 is 0 or 1, m3 is 0 or 1, and m4 is an integer of 0 to 2, provided that, when m3 is 1, m1 and m2 are not both 0 at the same time, *3 represents a bond bonded to a nitrogen atom in formula (3-2), and *4 represents a bond.
[4] The resist underlayer film-forming composition according to any one of [1] to [3], wherein the solvent (B) contains at least one type selected from a group consisting of an alkylene glycol monoalkyl ether and a monocarboxylic acid ester of an alkylene glycol monoalkyl ether.
[5] The resist underlayer film-forming composition according to any one of [1] to [4], further containing a crosslinking agent (C).
[6] The resist underlayer film-forming composition according to any one of [1] to [5], further containing a curing catalyst (D).
[7] A resist underlayer film, which is a cured product of the resist underlayer film-forming composition according to any one of [1] to [6].
[8] A laminate, including:
   a semiconductor substrate; and
   the resist underlayer film according to [7].
[9] A semiconductor element producing method, including steps of:
   forming a resist underlayer film on a semiconductor substrate using the resist underlayer film-forming composition according to any one of [1] to [6]; and
   forming a resist film on the resist underlayer film.
[10] A pattern forming method, including steps of:
   forming a resist underlayer film on a semiconductor substrate using the resist underlayer film-forming composition according to any one of [1] to [6];
   forming a resist film on the resist underlayer film;
   irradiating the resist film with light or an electron beam, and then developing the resist film to obtain a resist pattern; and
   etching the resist underlayer film using the resist pattern as a mask.

### Advantageous Effects of Invention

According to the present invention, it is possible to provide a resist underlayer film-forming composition capable of forming a resist underlayer film which has a high etching rate without deteriorating lithographic properties, and a resist underlayer film, a laminate, a semiconductor element producing method, and a pattern forming method using the resist underlayer film-forming composition.

### Description of Embodiments

### (Resist underlayer film-forming composition)

The resist underlayer film-forming composition of the present invention contains a polymer (A) having a repeating unit represented by formula (1) below and a solvent (B).

The resist underlayer film-forming composition may contain a crosslinking agent (C), a curing catalyst (D), and the like.

The polymer (A) has an iodine atom directly bonded to a ring structure.

Since the polymer (A) has an iodine atom directly bonded to a ring structure, the etching rate of the resist underlayer film can be increased without deteriorating lithographic properties (for example, sensitivity and resist pattern) as compared with a case where the polymer (A) does not have an iodine atom directly bonded to a ring structure.

### <Polymer (A)>

The polymer (A) has a repeating unit represented by formula (1) below. 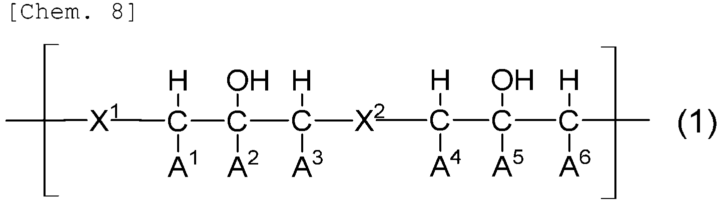
In formula (1), X¹ represents a divalent group having a ring structure and an iodine atom directly bonded to the ring structure,
X² represents a divalent group, and
A¹, A², A³, A⁴, A⁵, and A⁶ each independently represent a hydrogen atom, a methyl group, or an ethyl group.
A¹, A², A³, A⁴, A⁵, and A⁶ are preferably a hydrogen atom.

### <<X¹>>

The number of carbon atoms of X¹ in formula (1) is not particularly limited, and is, for example, 4 to 20.

X¹ has at least an iodine atom and a carbon atom as atoms included in the divalent group. X¹ may further have a hydrogen atom, an oxygen atom, a nitrogen atom, or the like as an atom included in the divalent group.

The ring structure in X¹ may be an aromatic ring or a non-aromatic ring.

The ring structure may be a hydrocarbon ring or a hetero ring.

As the ring structure, an aromatic ring is preferred, and an aromatic hydrocarbon ring is more preferred. Examples of the aromatic hydrocarbon ring include a benzene ring, a naphthalene ring, and an anthracene ring.

Examples of the non-aromatic hydrocarbon ring include a cyclohexane ring.

The ring structure is preferably a uracil ring or a pyrimidinetrione ring.

Uracil is a heterocyclic compound represented by the following formula.

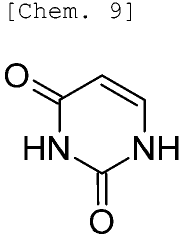

The pyrimidinetrione is a heterocyclic compound represented by the following formula.

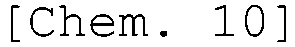

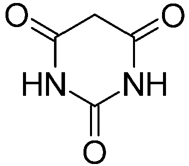

The number of iodine atoms directly bonded to one ring structure may be one or two or more.

X¹ in formula (1) preferably represents either a group represented by formula (2-1) below or a group represented by formula (2-2) below from the viewpoint of suitably obtaining the effect of the present invention.

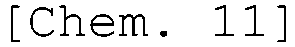

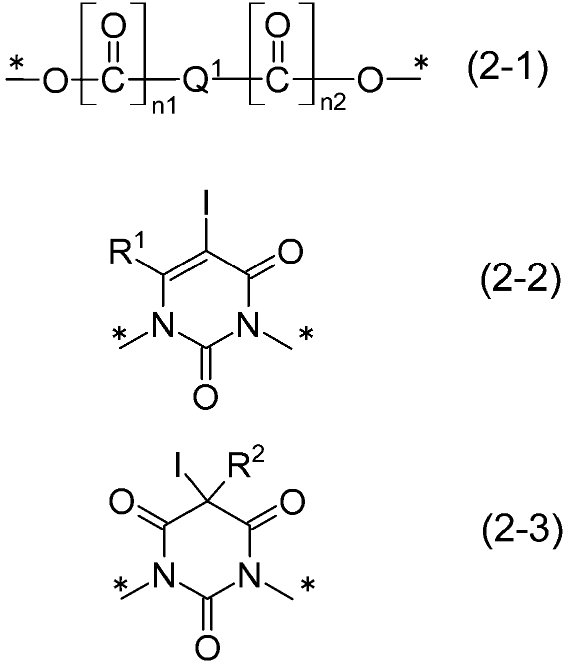

In formula (2-1), Q¹ represents a divalent organic group represented by formula (2-1-1) below, a divalent organic group represented by formula (2-1-2) below, a divalent organic group represented by formula (2-1-3) below, or a divalent organic group represented by formula (2-1-4) below. n1 and n2 each independently represent 0 or 1. * represents a bond.

In formula (2-2), R¹ represents a hydrogen atom, a halogen atom, or an organic group having 1 to 10 carbon atoms. * represents a bond.

In formula (2-3), R² represents a hydrogen atom, a halogen atom, or an organic group having 1 to 10 carbon atoms. * represents a bond.

In formula (2-2) and formula (2-3), "I" represents an iodine atom. 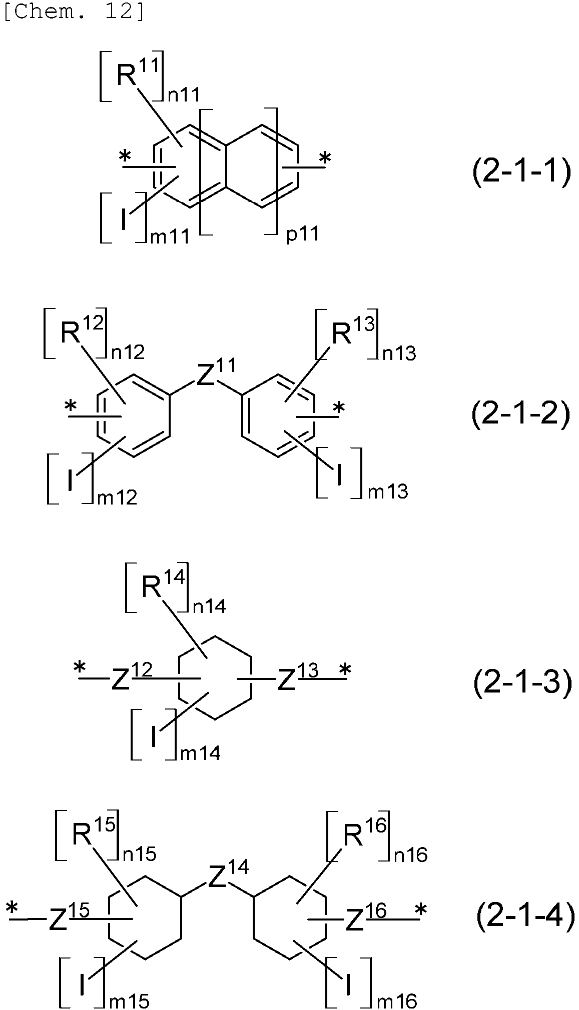 in formulae (2-1-1) to (2-1-4), R¹¹ to R¹⁶ each independently represent a halogen atom (exclusive of an iodine atom), a hydroxy group, a cyano group, an alkyl group having 1 to 6 carbon atoms, an alkenyl group having 2 to 6 carbon atoms, an alkynyl group having 2 to 6 carbon atoms, an alkoxy group having 1 to 6 carbon atoms, an alkenyloxy group having 2 to 6 carbon atoms, an alkynyloxy group having 2 to 6 carbon atoms, an acyl group having 2 to 6 carbon atoms, an aryloxy group having 6 to 12 carbon atoms, an arylcarbonyl group having 7 to 13 carbon atoms, an aralkyl group having 7 to 13 carbon atoms, or -N(R^{a})(R^{b}) (R^{a} and R^{b} each independently represent a hydrogen atom or an alkyl group having 1 to 6 carbon atoms), and * represents a bond,
In formula (2-1-1), p11 represents an integer of 0 to 2, when p11 is 0, m11 represents an integer of 1 to 4, n11 represents an integer of 0 to 3, and a sum of m11 and n11 is 4 or less, when p11 is 1, m11 represents an integer of 1 to 6, n11 represents an integer of 0 to 5, and a sum of m11 and n11 is 6 or less, when p11 is 2, m11 represents an integer of 1 to 8, n11 represents an integer of 0 to 7, and a sum of m11 and n11 is 8 or less, and when two or more R¹¹'s are present, the two or more R¹¹'s may be identical or different.

In formula (2-1-2), Z¹¹ represents a single bond, an oxygen atom, a sulfur atom, a carbonyl group, a sulfonyl group, or an alkylene group having 1 to 6 carbon atoms, m12 and m13 each independently represent an integer of 0 to 4, n12 and n13 each independently represent an integer of 0 to 4, a sum of m12 and m13 is 1 or more, a sum of m12 and n12 is 4 or less, and a sum of m13 and n13 is 4 or less, when two or more R¹²'s are present, the two or more R¹²'s may be identical or different, and when two or more R¹³'s are present, the two or more R¹³'s may be identical or different.

In formula (2-1-3), Z¹² and Z¹³ each independently represent a single bond or a linear or branched alkylene group having 1 to 6 carbon atoms, m14 represents an integer of 1 to 4, n14 represents an integer of 0 to 3, and a sum of m14 and n14 is 4 or less, and when two or more R¹⁴'s are present, the two or more R¹⁴'s may be identical or different.

In formula (2-1-4), Z¹⁴ represents a single bond, an oxygen atom, a sulfur atom, a carbonyl group, a sulfonyl group, or an alkylene group having 1 to 6 carbon atoms, Z¹⁵ and Z¹⁶ each independently represent a single bond or a linear or branched alkylene group having 1 to 6 carbon atoms, m15 and m16 each independently represent an integer of 0 to 4, n15 and n16 each independently represent an integer of 0 to 4, a sum of m15 and m16 is 1 or more, a sum of m15 and n15 is 4 or less, and a sum of m16 and n16 is 4 or less, when two or more R¹⁵'s are present, the two or more R¹⁵'s may be identical or different, and when two or more R¹⁶'s are present, the two or more R¹⁶'s may be identical or different.

In formulae (2-1-1) to (2-1-4), "I" represents an iodine atom.

Examples of the organic group having 1 to 10 carbon atoms in R¹ in formula (2-2) and R² in formula (2-3) include an alkyl group having 1 to 6 carbon atoms which may have a substituent, and an alkenyl group having 2 to 6 carbon atoms which may have a substituent. Examples of the substituent include a halogen atom and an alkoxy group having 1 to 6 carbon atoms.

Examples of the group represented by formula (2-1) include divalent groups represented by the following formulae. These are merely examples, and the group represented by formula (2-1) is not limited thereto. 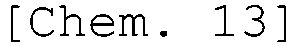 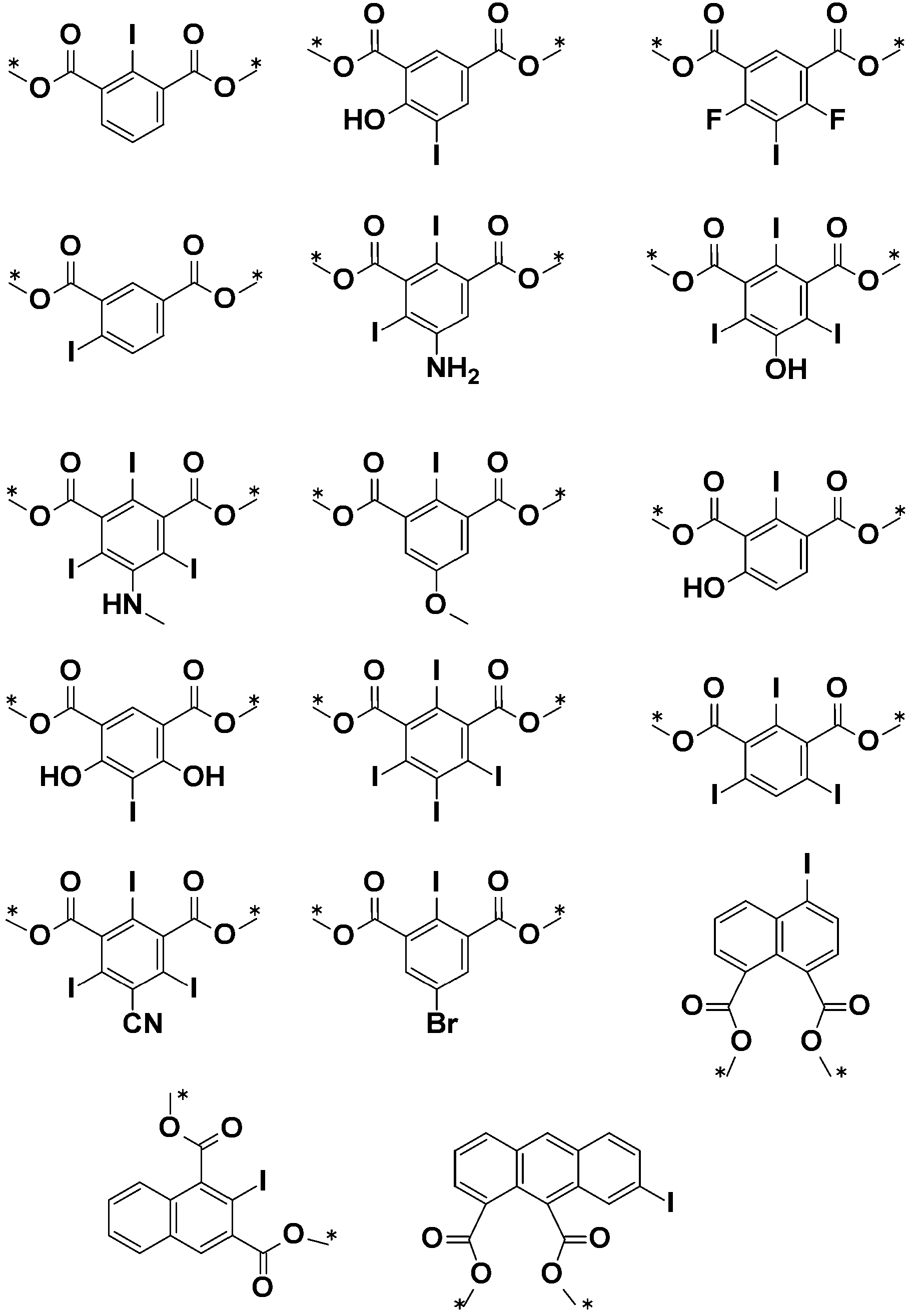 * represents a bond.

Examples of the group represented by formula (2-2) include divalent groups represented by the following formulae. These are merely examples, and the group represented by formula (2-2) is not limited thereto. 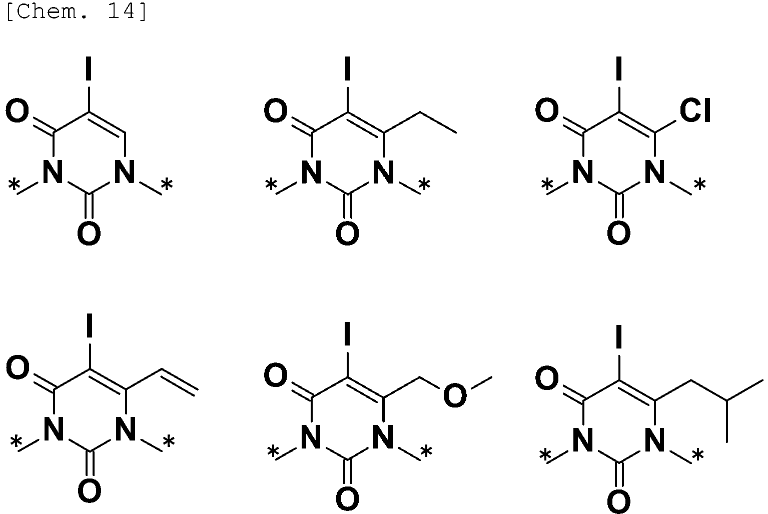 * represents a bond.

Examples of the group represented by formula (2-3) include divalent groups represented by the following formulae. These are merely examples, and the group represented by formula (2-3) is not limited thereto. 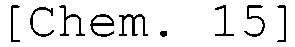 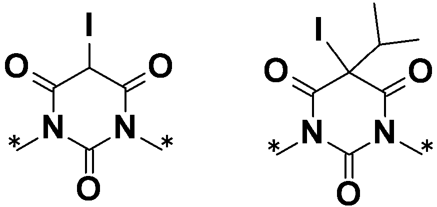 * represents a bond.

### <<X²>>

X² in formula (1) is not particularly limited as long as it is a divalent group, and may be the same divalent group as X¹ or a divalent group different from X¹.

The number of carbon atoms of X² is not particularly limited, and is, for example, 4 to 20.

X² has at least a carbon atom as an atom included in the divalent group. X¹ may further have a hydrogen atom, an oxygen atom, a nitrogen atom, or the like as an atom included in the divalent group.

X² in formula (1) preferably represents either a group represented by formula (3-1) below or a group represented by formula (3-2) below from the viewpoint of suitably obtaining the effect of the present invention.

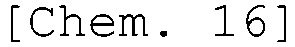

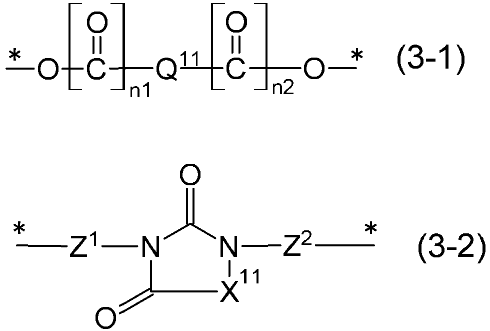

In formula (3-1), Q¹¹ represents a divalent acyclic hydrocarbon group having 2 to 20 carbon atoms which may be interrupted by an oxygen atom, a divalent organic group represented by formula (3-1-1) below, a divalent organic group represented by formula (3-1-2) below, a divalent organic group represented by formula (3-1-3) below, or a divalent organic group represented by formula (3-1-4) below, n1 and n2 each independently represent 0 or 1, and * represents a bond,
In formula (3-2), X¹¹ represents a divalent group represented by any of formulae (3-2-1) to (3-2-3) below, Z¹ and Z² each independently represent a single bond or a divalent group represented by formula (2-2-4) below, and * represents a bond. 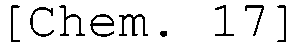 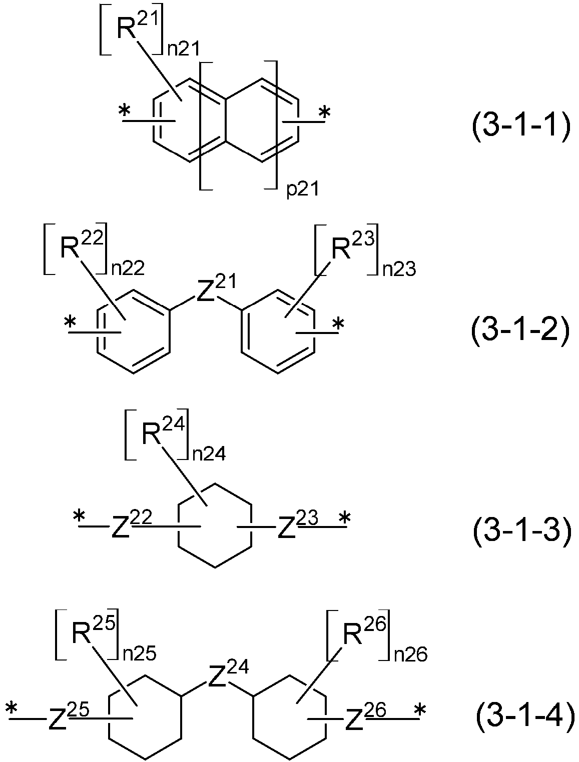 in formulae (3-1-1) to (3-1-4), R²¹ to R²⁶ each independently represent a halogen atom, a hydroxy group, a cyano group, an alkyl group having 1 to 6 carbon atoms, an alkenyl group having 2 to 6 carbon atoms, an alkynyl group having 2 to 6 carbon atoms, an alkoxy group having 1 to 6 carbon atoms, an alkenyloxy group having 2 to 6 carbon atoms, an alkynyloxy group having 2 to 6 carbon atoms, an acyl group having 2 to 6 carbon atoms, an aryloxy group having 6 to 12 carbon atoms, an arylcarbonyl group having 7 to 13 carbon atoms, or an aralkyl group having 7 to 13 carbon atoms, and * represents a bond,
In formula (3-1-1), p21 represents an integer of 0 to 2, when p21 is 0, n21 represents an integer of 0 to 4, when p21 is 1, n21 represents an integer of 0 to 6, when p21 is 2, n21 represents an integer of 0 to 8, and when two or more R²¹'s are present, the two or more R²¹'s may be identical or different.

In formula (3-1-2), Z²¹ represents a single bond, an oxygen atom, a sulfur atom, a carbonyl group, a sulfonyl group, or an alkylene group having 1 to 6 carbon atoms, n22 and n23 each independently represent an integer of 0 to 4, when two or more R²²'s are present, the two or more R²²'s may be identical or different, and when two or more R²³'s are present, the two or more R²³'s may be identical or different.

In formula (3-1-3), Z²² and Z²³ each independently represent a single bond or a linear or branched alkylene group having 1 to 6 carbon atoms, n24 represents an integer of 0 to 4, and when two or more R²⁴'s are present, the two or more R²⁴'s may be identical or different.

In formula (3-1-4), Z²⁴ represents a single bond, an oxygen atom, a sulfur atom, a carbonyl group, a sulfonyl group, or an alkylene group having 1 to 6 carbon atoms, Z²⁵ and Z²⁶ each independently represent a single bond or a linear or branched alkylene group having 1 to 6 carbon atoms, n25 and n26 each independently represent an integer of 0 to 4, when two or more R²⁵'s are present, the two or more R²³'s may be identical or different, and when two or more R²⁶'s are present, the two or more R²⁶'s may be identical or different.

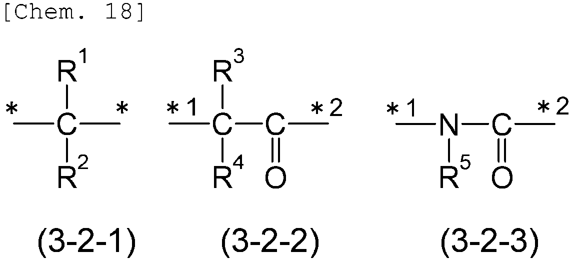

In formulae (3-2-1) to (3-2-3), R¹ to R⁵ each independently represent a hydrogen atom, an alkyl group having 1 to 10 carbon atoms which may be interrupted by an oxygen atom or a sulfur atom, an alkenyl group having 2 to 10 carbon atoms which may be interrupted by an oxygen atom or a sulfur atom, an alkynyl group having 2 to 10 carbon atoms which may be interrupted by an oxygen atom or a sulfur atom, a benzyl group, or a phenyl group, wherein the phenyl group may be substituted with at least one monovalent group selected from a group consisting of an alkyl group having 1 to 6 carbon atoms, a halogen atom, an alkoxy group having 1 to 6 carbon atoms, a nitro group, a cyano group, and an alkylthio group having 1 to 6 carbon atoms, R¹ and R² may be bonded to each other to form a ring having 3 to 6 carbon atoms, and R³ and R⁴ may be bonded to each other to form a ring having 3 to 6 carbon atoms,
* represents a bond, *1 represents a bond bonded to a carbon atom in formula (3-2), and *2 represents a bond bonded to a nitrogen atom in formula (3-2).

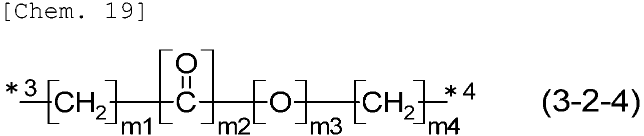

In formula (3-2-4), m1 is an integer of 0 to 4, m2 is 0 or 1, m3 is 0 or 1, and m4 is an integer of 0 to 2, provided that, when m3 is 1, m1 and m2 are not both 0 at the same time, *3 represents a bond bonded to a nitrogen atom in formula (3-2), and *4 represents a bond.

In the present description, examples of the halogen atom include a fluorine atom, a chlorine atom, a bromine atom, and an iodine atom.

In the present description, the alkyl group is not limited to a linear alkyl group, and may be branched or cyclic. Examples of the linear or branched alkyl group include a methyl group, an ethyl group, an isopropyl group, a tert-butyl group, and a n-hexyl group. Examples of the cyclic alkyl group (cycloalkyl group) include a cyclobutyl group, a cyclopentyl group, and a cyclohexyl group.

In the present description, examples of the alkoxy group include a methoxy group, an ethoxy group, a n-pentyloxy group, and an isopropoxy group.

In the present description, examples of the alkylthio group include a methylthio group, an ethylthio group, a n-pentylthio group, and an isopropylthio group.

In the present description, examples of the alkenyl group include an ethenyl group, a 1-propenyl group, a 2-propenyl group, a 1-methyl-1-ethenyl group, a 1-butenyl group, a 2-butenyl group, a 3-butenyl group, a 2-methyl-1-propenyl group, and a 2-methyl-2-propenyl group.

In the present description, examples of the alkynyl group include a group in which a double bond of an alkenyl group listed above as the "alkenyl group" is replaced with a triple bond.

In the present description, examples of the alkenyloxy group include a vinyloxy group, a 1-propenyloxy group, a 2-n-propenyloxy group (allyloxy group), a 1-n-butenyloxy group, and a prenyloxy group.

In the present description, examples of the alkynyloxy group include a 2-propynyloxy group, a 1-methyl-2-propynyloxy group, a 2-methyl-2-propynyloxy group, a 2-butynyloxy group, and a 3-butynyloxy group.

In the present description, examples of the acyl group include an acetyl group and a propionyl group.

In the present description, examples of the aryloxy group include a phenoxy group and naphthyloxy.

In the present description, examples of the arylcarbonyl group include a phenylcarbonyl group.

In the present description, examples of the aralkyl group include a benzyl group and a phenethyl group.

In the present description, examples of the alkylene group include a methylene group, an ethylene group, a 1,3-propylene group, a 2,2-propylene group, a 1-methylethylene group, a 1,4-butylene group, a 1-ethylethylene group, a 1-methylpropylene group, a 2-methylpropylene group, a 1,5-pentylene group, a 1-methylbutylene group, a 2-methylbutylene group, a 1,1-dimethylpropylene group, a 1,2-dimethylpropylene group, a 1-ethylpropylene group, a 2-ethylpropylene group, a 1,6-hexylene group, a 1,4-cyclohexylene group, a 1,8-octylene group, a 2-ethyloctylene group, a 1,9-nonylene group, and a 1,10-decylene group.

Examples of the alkyl group having 1 to 10 carbon atoms which may be interrupted by an oxygen atom or a sulfur atom of R¹ to R⁵ in formulae (3-2-1) to (3-2-3) include an alkyl group having 1 to 10 carbon atoms, an alkoxy group having 1 to 10 carbon atoms, an alkoxyalkyl group having 2 to 10 carbon atoms, an alkoxyalkoxyalkyl group having 3 to 10 carbon atoms, an alkylthio group having 1 to 10 carbon atoms, and an alkylthioalkyl group having 2 to 10 carbon atoms.

In addition, the alkyl group having 1 to 10 carbon atoms which may be interrupted by an oxygen atom or a sulfur atom may contain two or more oxygen atoms or sulfur atoms.

Examples of the divalent acyclic hydrocarbon group having 2 to 20 carbon atoms which may be interrupted by an oxygen atom of Q¹¹ in formula (3-1) include an alkylene group having 2 to 10 carbon atoms, -CH₂CH₂-(OCH₂CH₂)ₙ- (n represents an integer of 1 to 9), and -CH(CH₃)CH₂-(OCH(CH₃)CH₂)ₙ- (n represents an integer of 1 to 5) .

The alkylene group having 2 to 10 carbon atoms may be linear or branched.

Examples of the group represented by formula (3-1) include structures exemplified below.

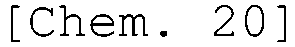

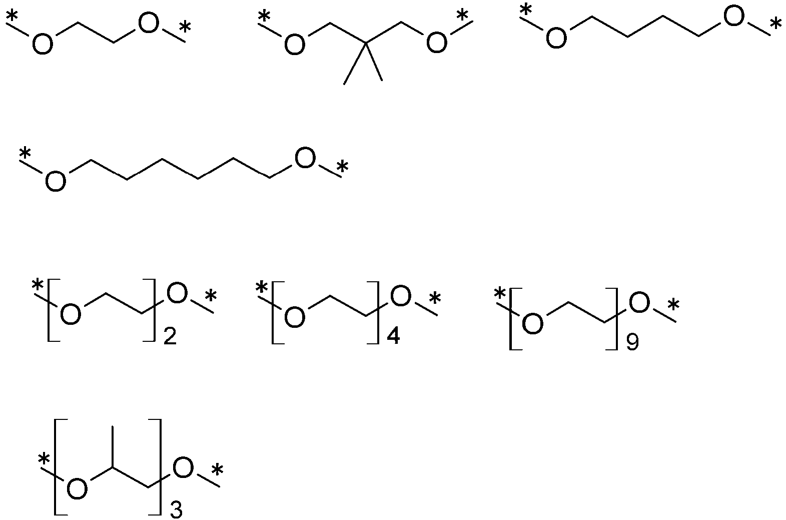

The above examples are examples when Q¹¹ in formula (3-1) is a divalent acyclic hydrocarbon group having 2 to 20 carbon atoms which may be interrupted by an oxygen atom. 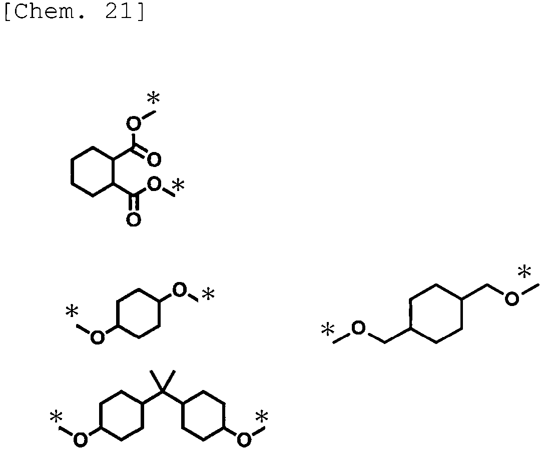 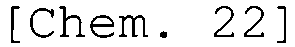 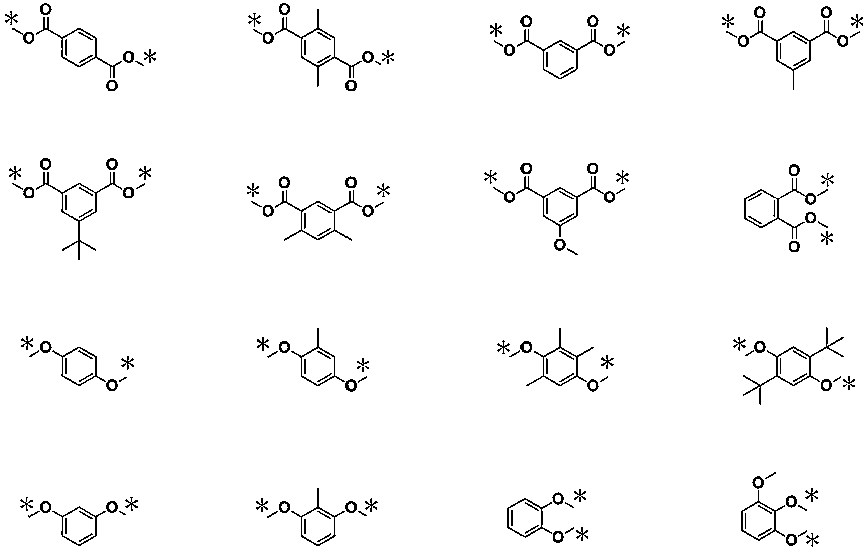 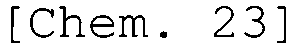 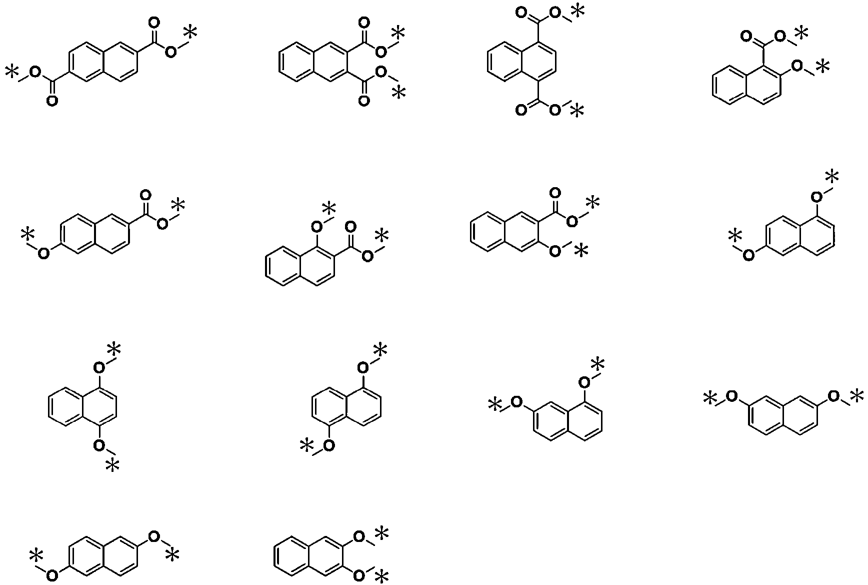 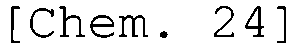 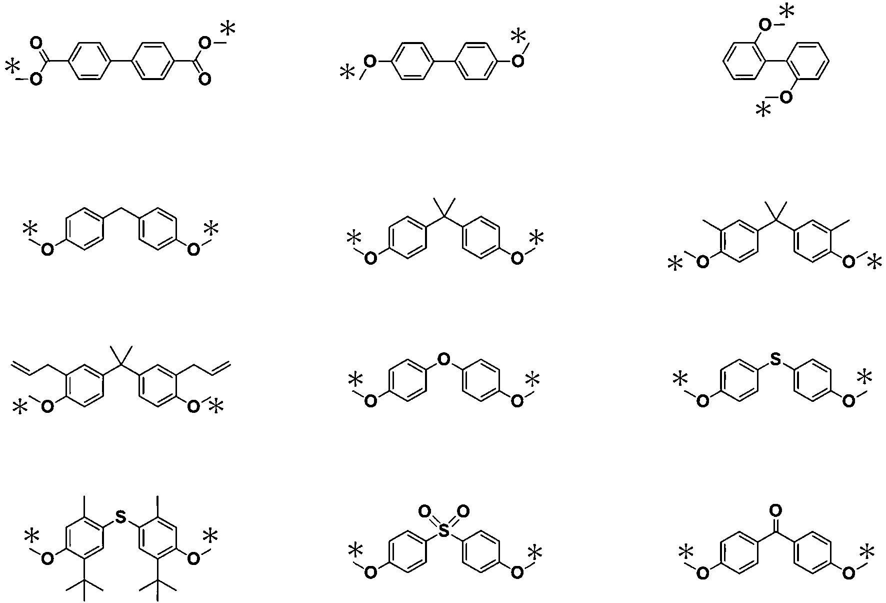 * represents a bond.

Examples of the group represented by formula (3-2) include structures exemplified below. 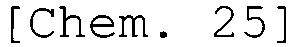 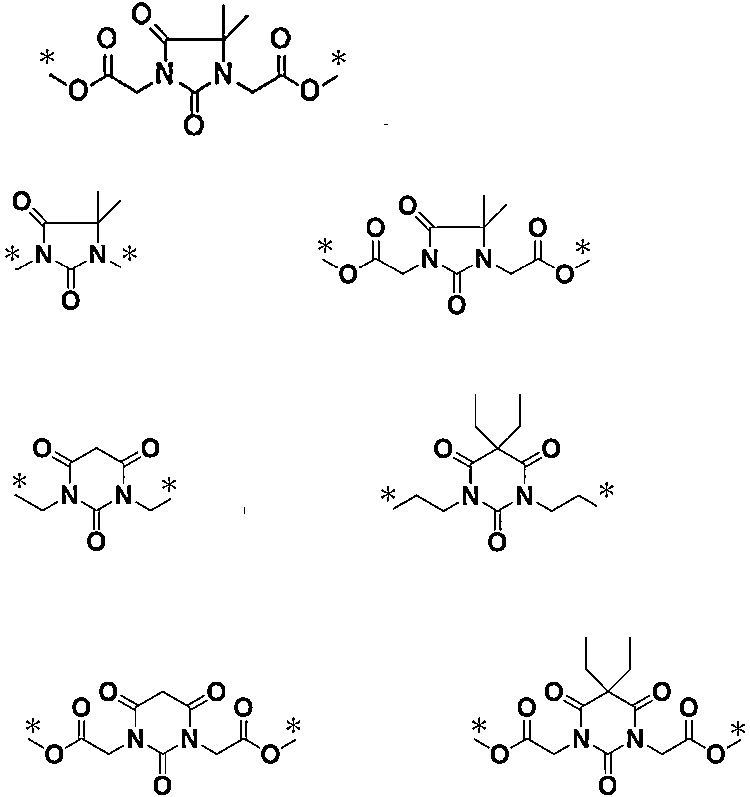 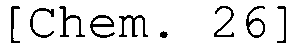 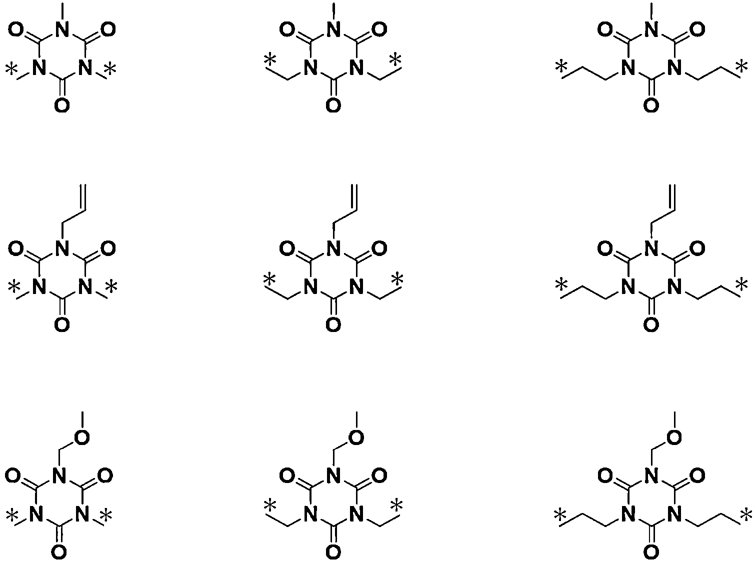 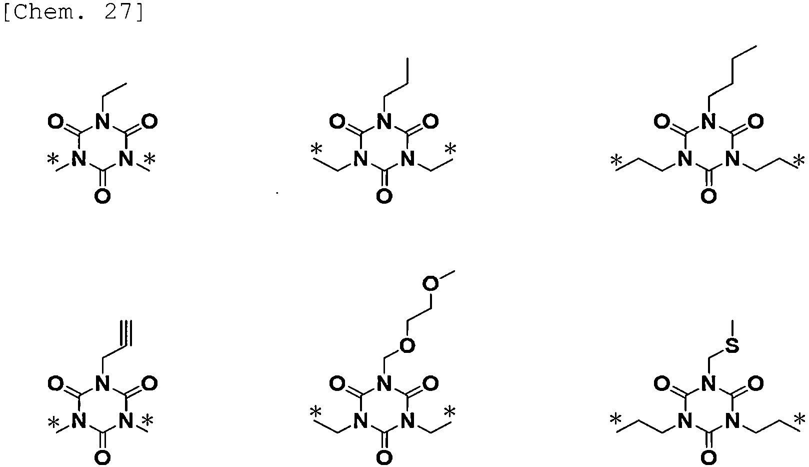 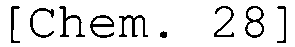 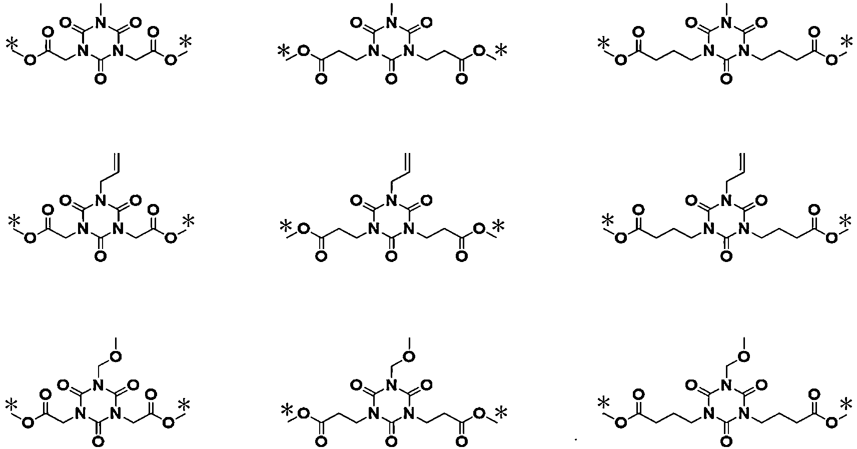 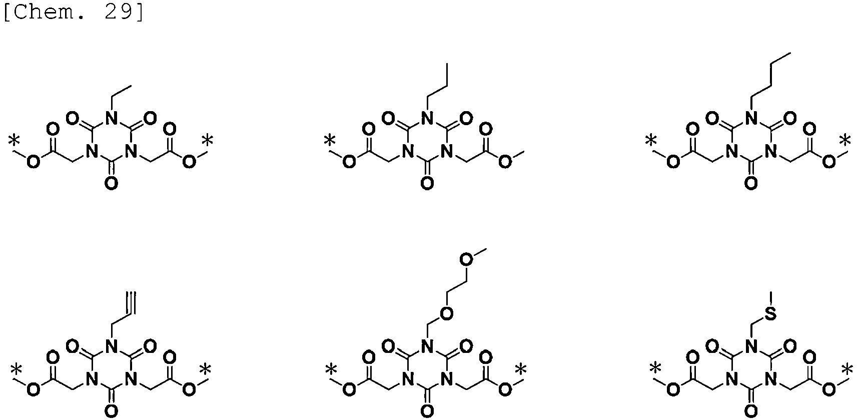 * represents a bond.

The polymer (A) may further have, at a terminal, an aliphatic ring which contains a carbon-carbon bond that may be interrupted by a heteroatom. The aliphatic ring may be substituted with a substituent.

The polymer (A) is, for example, a linear polymer. The linear polymer (A) preferably has the aliphatic ring at both terminals.

Examples of the substituent in the aliphatic ring which may be substituted with a substituent and contains a carbon-carbon bond that may be interrupted by a heteroatom include a hydroxy group, a carboxy group, an alkyl group having 1 to 6 carbon atoms, an acyl group having 1 to 6 carbon atoms, an alkoxy group having 1 to 6 carbon atoms, and an alkyloxycarbonyl group having 2 to 6 carbon atoms.

Examples of the size of the aliphatic ring include a 3-membered ring to a 10-membered ring.

The aliphatic ring may be a monocyclic ring or a polycyclic ring.

The aliphatic ring may be a saturated aliphatic ring or an unsaturated aliphatic ring.

The total number of carbon atoms of the aliphatic ring which may be substituted with a substituent and contains a carbon-carbon bond that may be interrupted by a heteroatom is, for example, 6 to 15.

The polymer (A) may have an aromatic ring to which at least one of a halogen atom and a hydroxy group may be bonded at a terminal. The halogen atom is preferably an iodine atom. Examples of the aromatic ring include an aromatic hydrocarbon ring and an aromatic heterocycle. Examples of the aromatic hydrocarbon ring include a benzene ring, a naphthalene ring, and an anthracene ring.

When an aliphatic ring in which a carbon-carbon bond may be interrupted by a heteroatom is represented as a monovalent organic group, the aliphatic ring is represented by, for example, formula (Z) below.
[Chem. 30]

Z-* (Z)

In formula (Z), Z represents a monovalent organic group obtained by removing one hydrogen atom from an aliphatic ring which may be substituted with a substituent and contains a carbon-carbon bond that may be interrupted by a heteroatom, and * represents a bond.

When the aromatic ring to which at least one of a halogen atom and a hydroxy group may be bonded is represented as a monovalent organic group, for example, the aromatic ring is represented by formula (Z) (wherein Z represents a monovalent organic group obtained by removing one hydrogen atom from the aromatic ring of the aromatic ring to which at least one of a halogen atom and a hydroxy group may be bonded.

Examples of Z include the following structures.

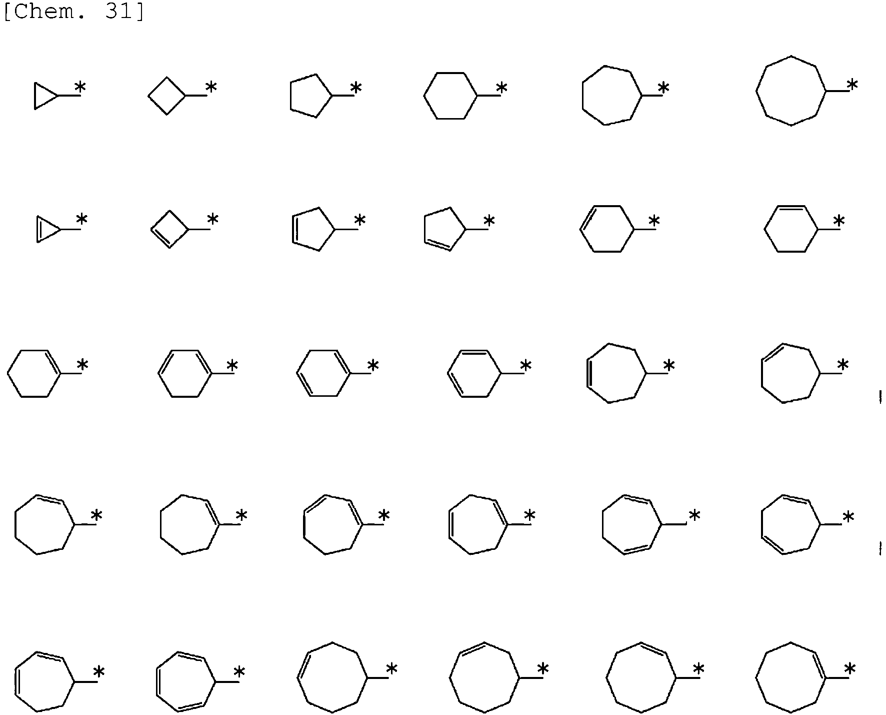

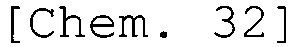

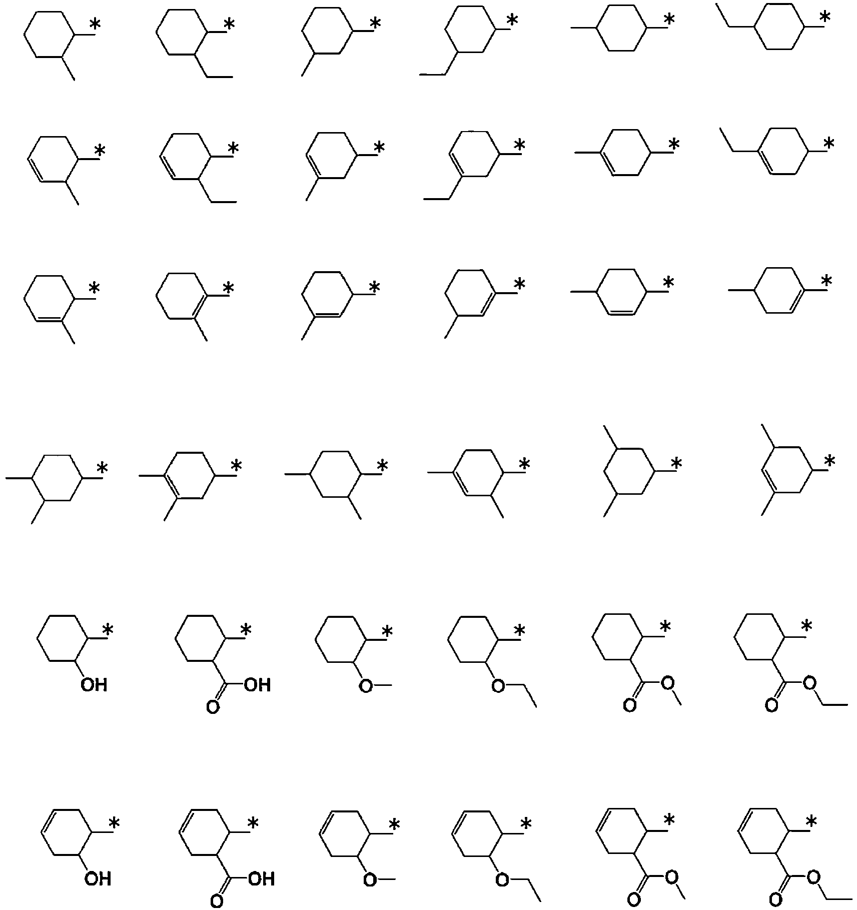

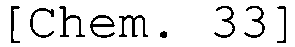

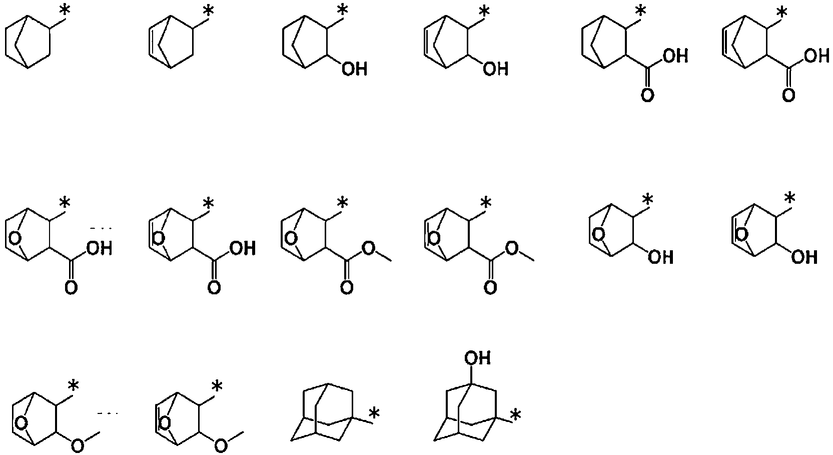

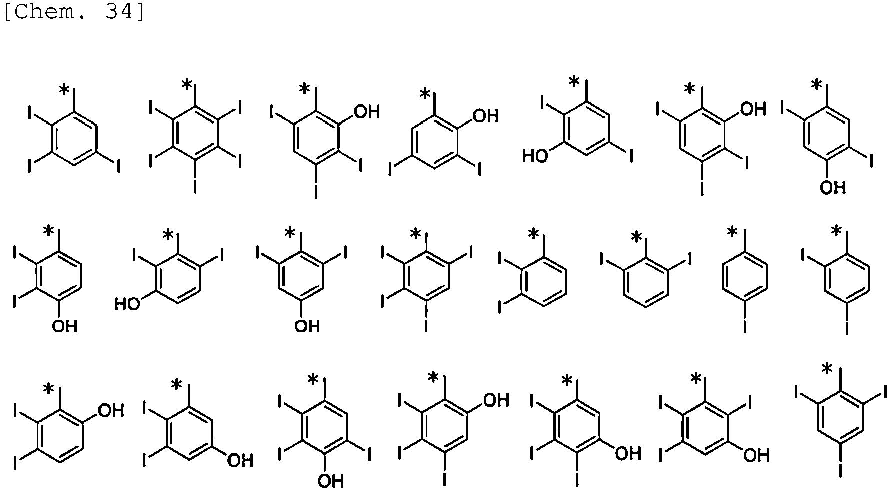

In the structures, * represents a bond.

"I" in the structures represents an iodine atom.

The molecular weight of the polymer (A) is not particularly limited.

The lower limit of the weight average molecular weight of the polymer (A) is, for example, 500, 1,000, 2,000, or 3,000.

The upper limit of the weight average molecular weight of the polymer (A) is, for example, 30,000, 20,000, or 10,000.

A method for producing an example of the polymer (A) will be described.

An example of the polymer (A) is obtained, for example, by the following reactions (I) to (II).

(I): A reaction between a compound represented by formula (1A) below and a compound represented by formula (1B) below.
(II): A reaction among a compound represented by formula (1A) below, a compound represented by formula (1B) below, and a monocarboxy compound having one carboxy group.

In the reactions (I) and (II), another compound may be used in combination.

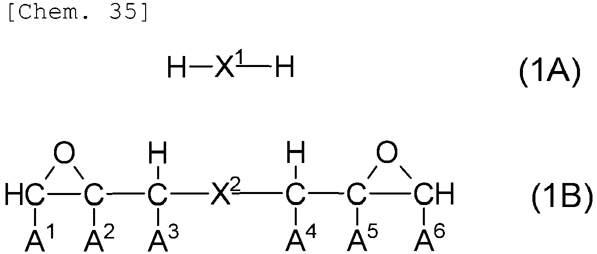

In formula (1A), X¹ has the same meaning as X¹ in formula (1).

In formula (1B), X², A¹, A², A³, A⁴, A⁵, and A⁶ have the same meanings as X², A¹, A², A³, A⁴, A⁵, and A⁶ in formula (1), respectively.

Examples of the compound represented by formula (1A) include a compound represented by formula (2-1A) below, a compound represented by formula (2-2A) below, and a compound represented by formula (2-3A) below.

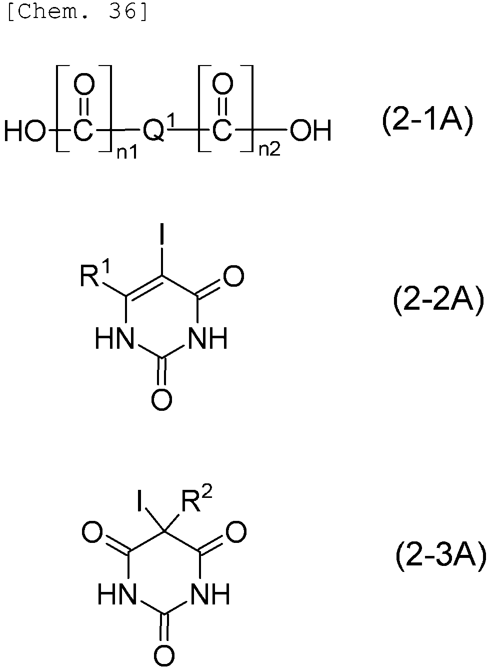

In formula (2-1A), Q¹, n1, and n2 have the same meanings as Q¹, n1, and n2 in formula (2-1), respectively.

In formula (2-2A), R¹ has the same meaning as R¹ in formula (2-2).

In formula (2-3A), R² has the same meaning as R¹ in formula (2-2).

In formula (2-2A) and formula (2-3A), "I" represents an iodine atom.

Examples of the compound represented by formula (2-1A) include the following compounds.

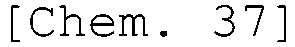

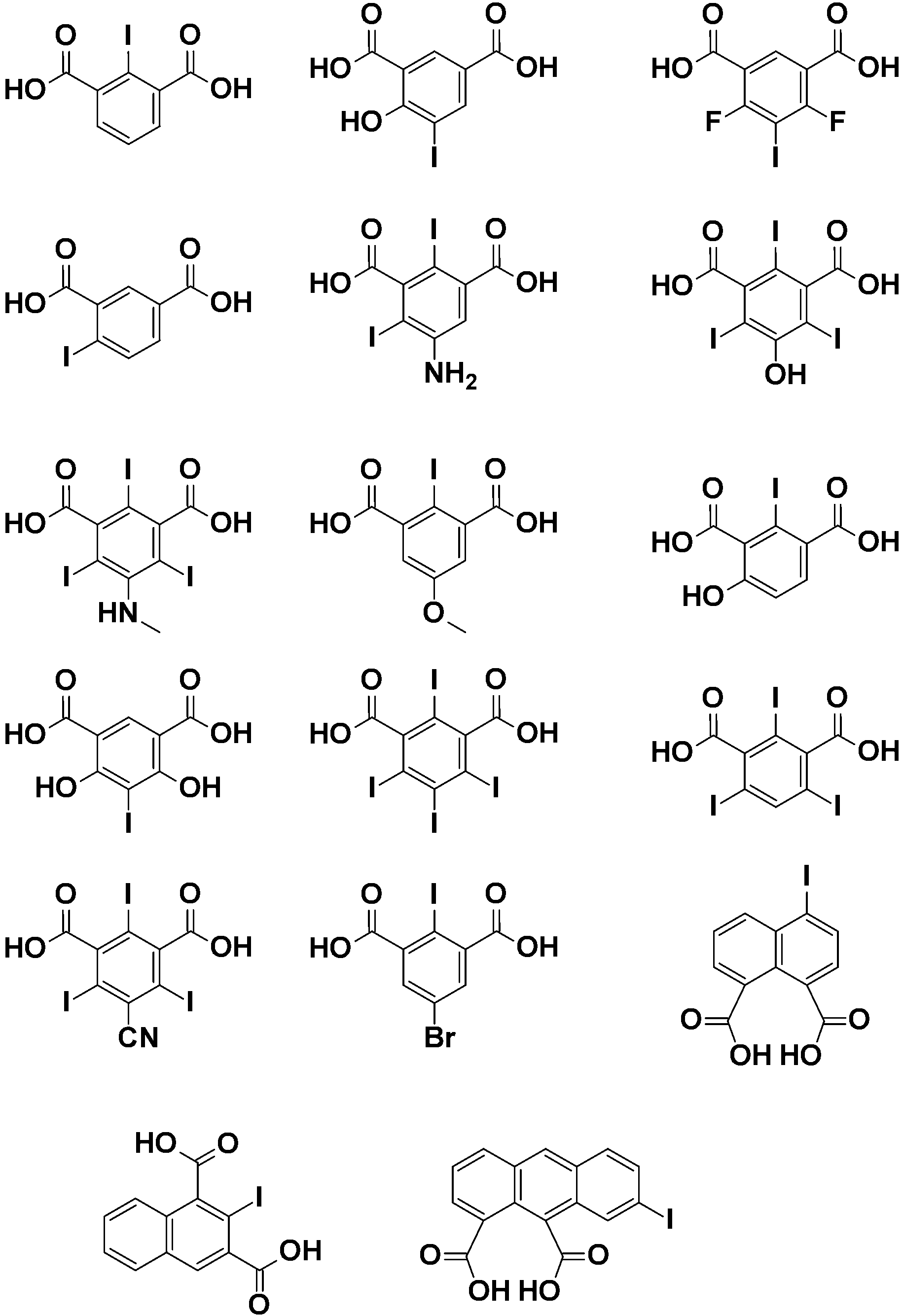

Examples of the compound represented by formula (2-2A) include the following compounds.

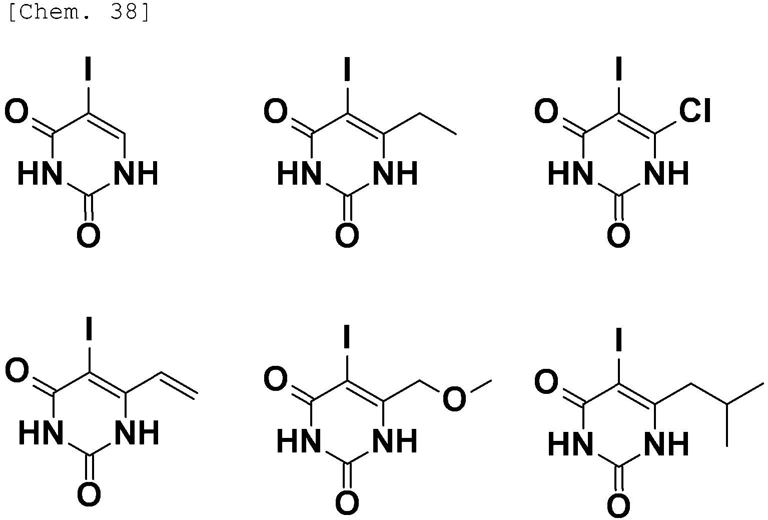

Examples of the compound represented by formula (2-3A) include the following compounds.

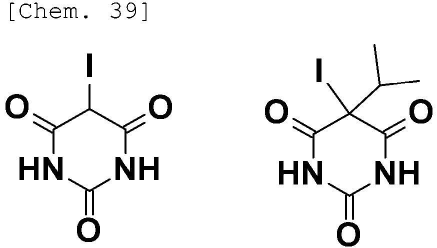

Examples of the compound represented by formula (1B) include the following compounds.

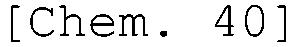

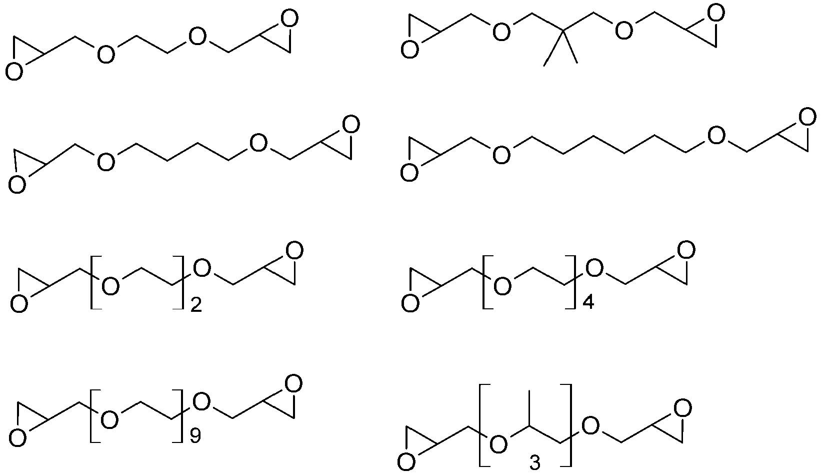

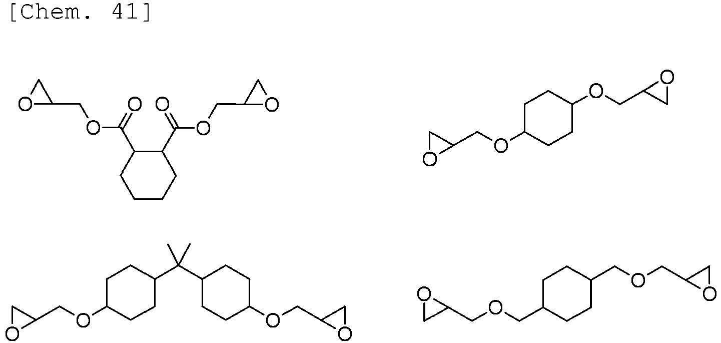

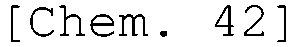

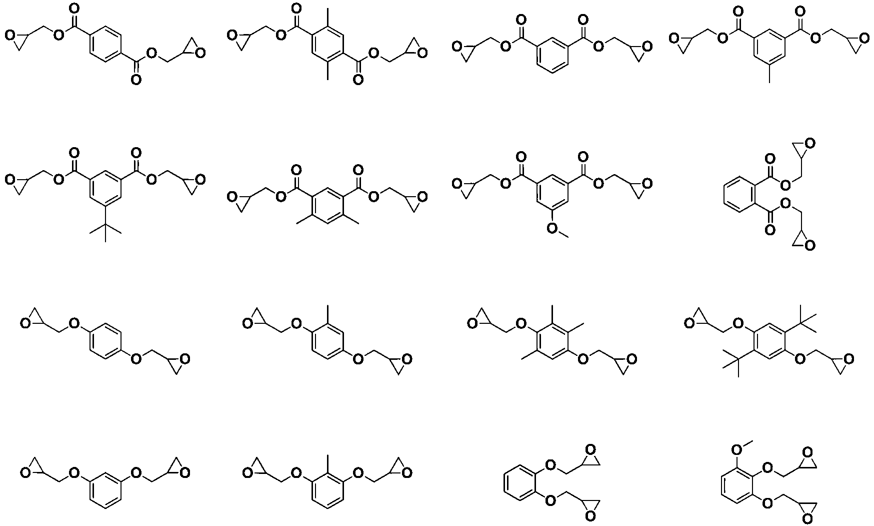

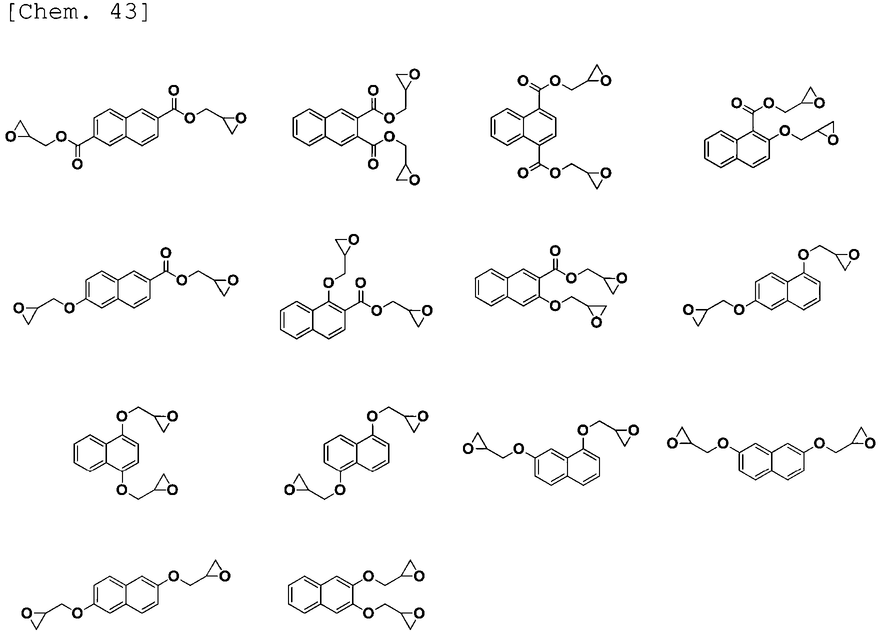

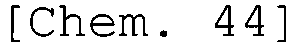

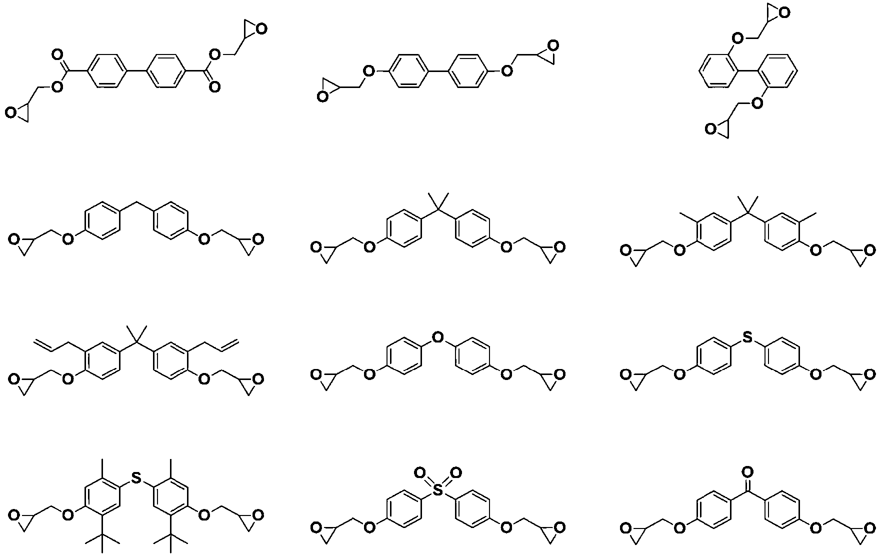

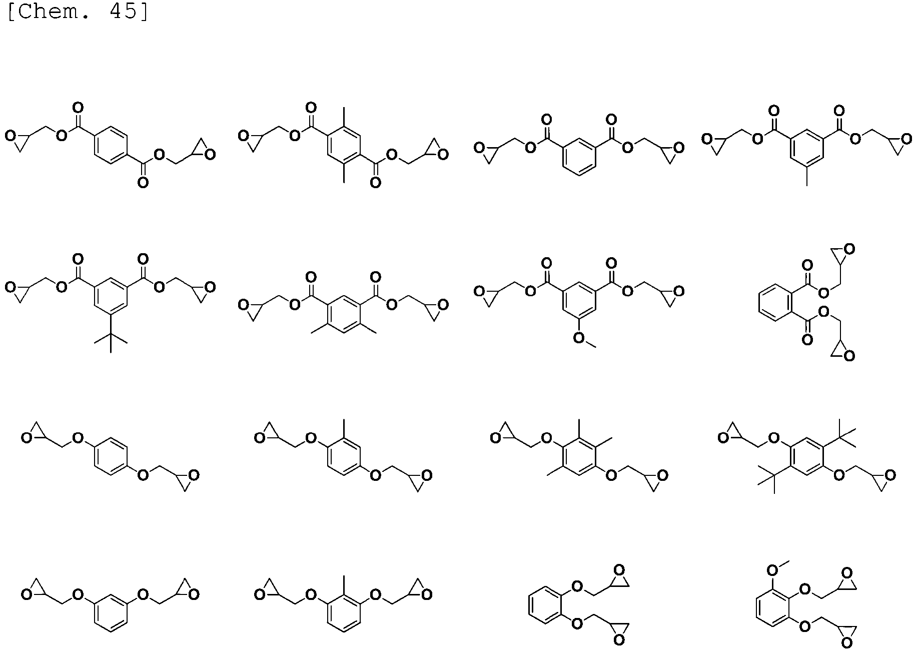

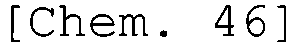

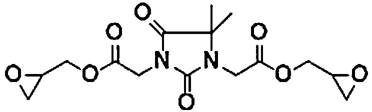

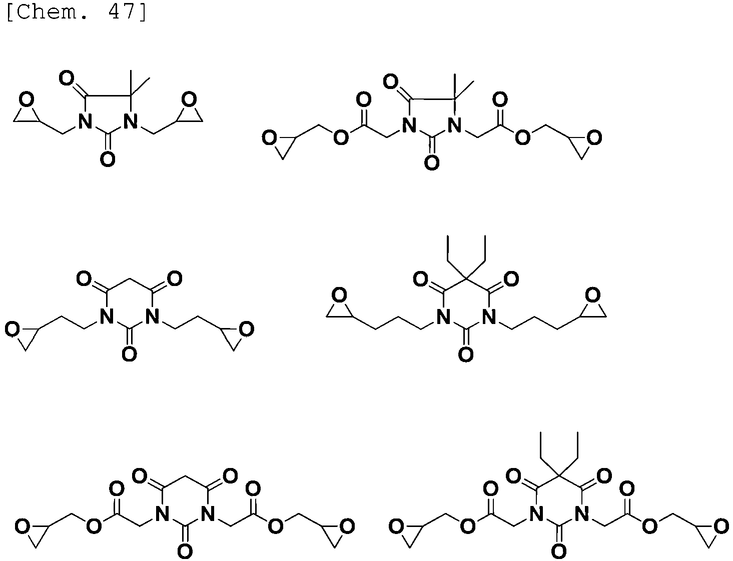

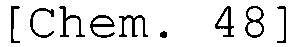

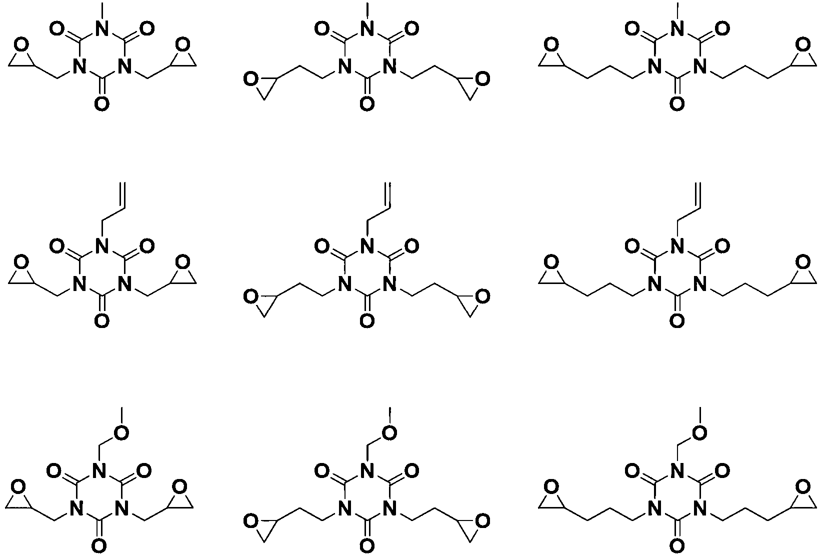

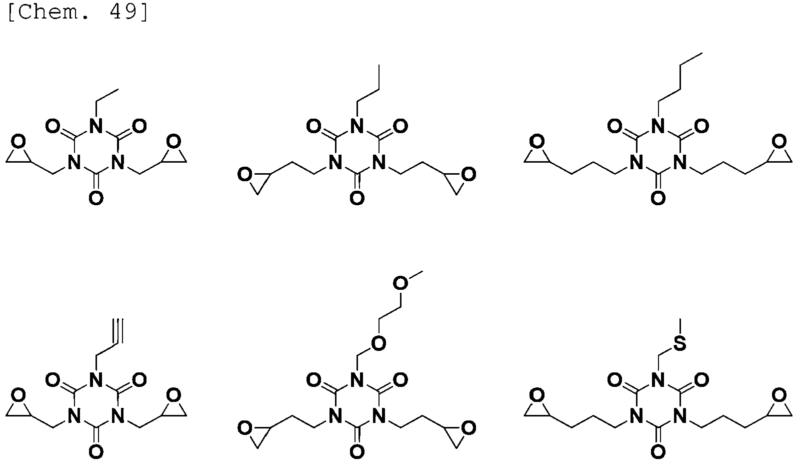

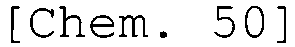

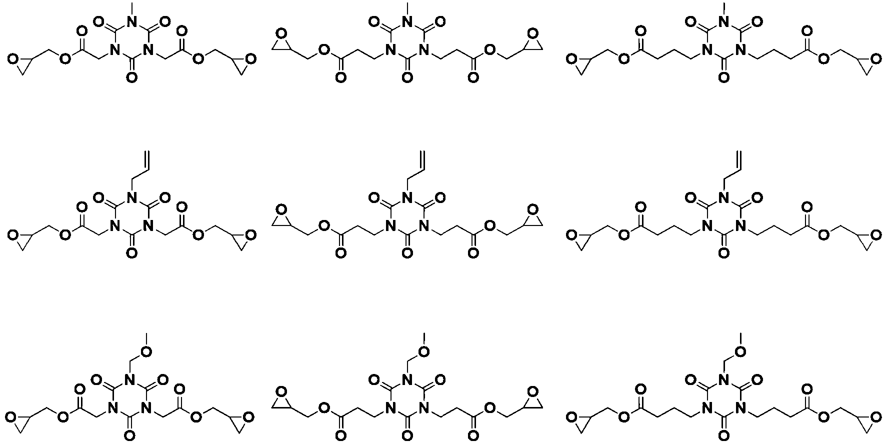

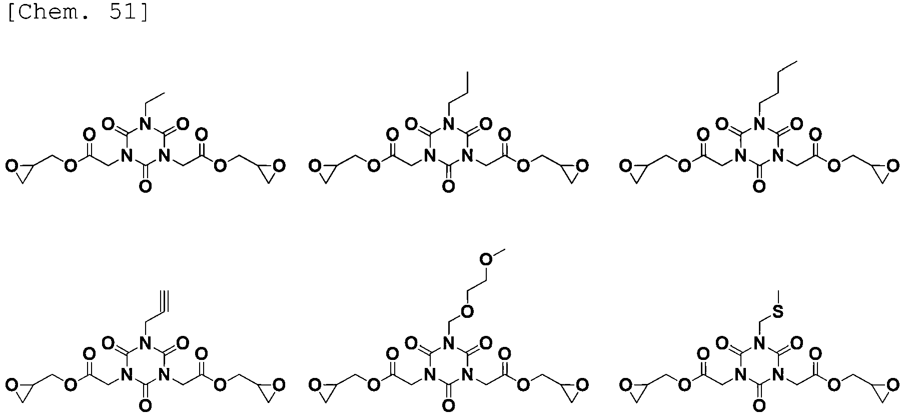

Examples of the monocarboxy compound having one carboxy group include a compound represented by formula (D1) below.

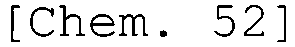

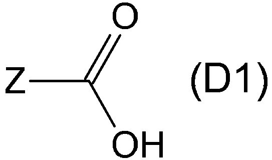

In formula (D1), Z has the same meaning as Z in formula (Z).

Examples of the compound represented by formula (D1) below include the following compounds.

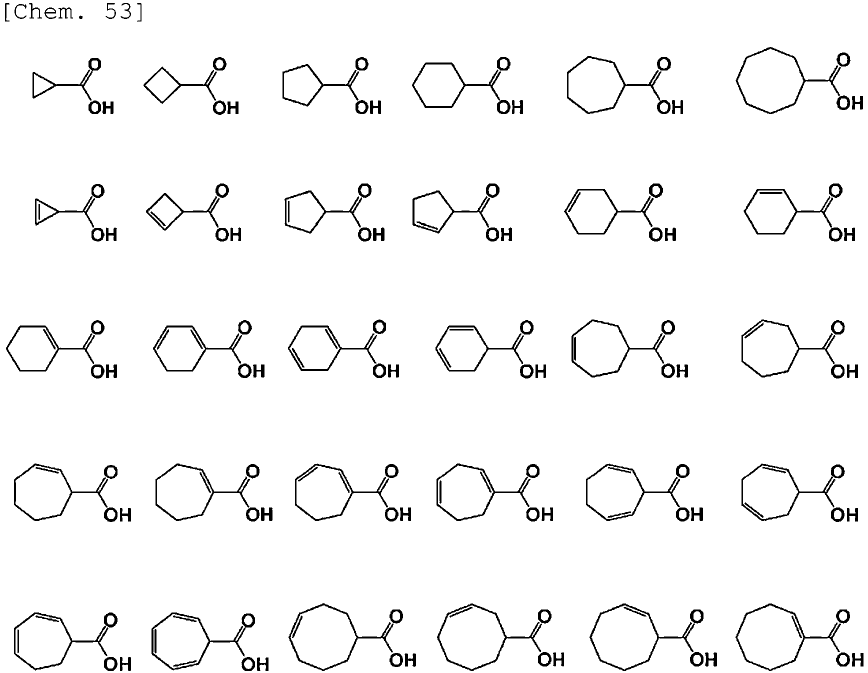

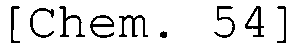

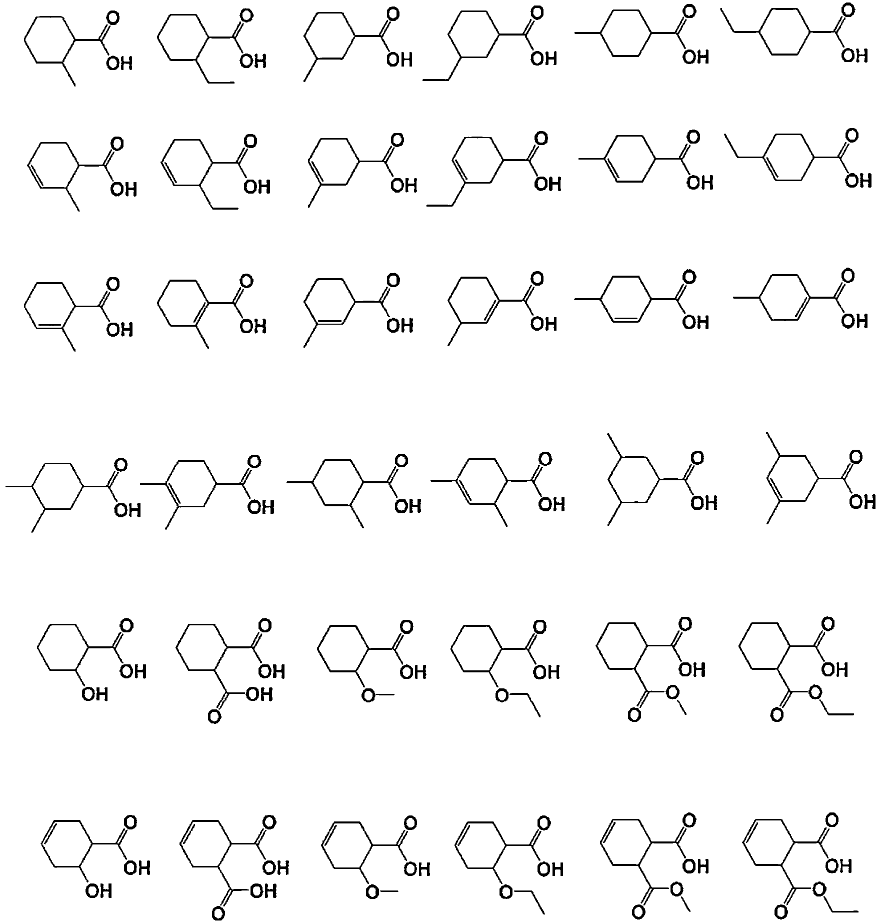

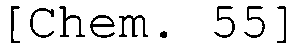

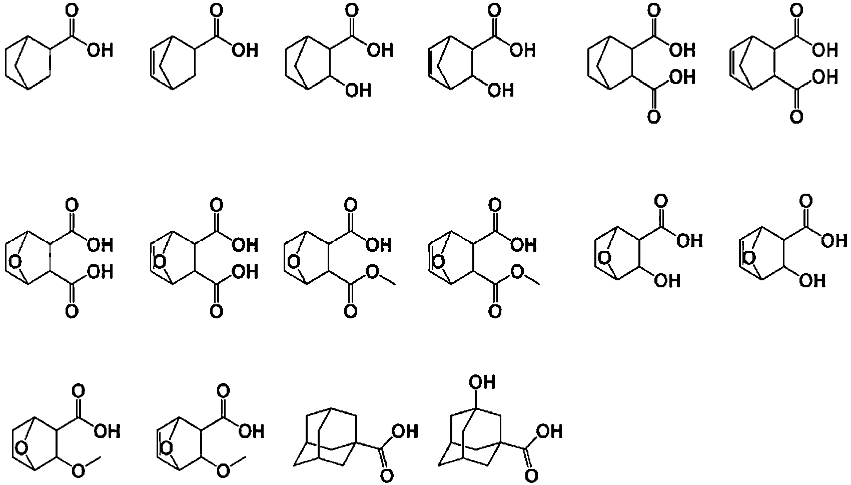

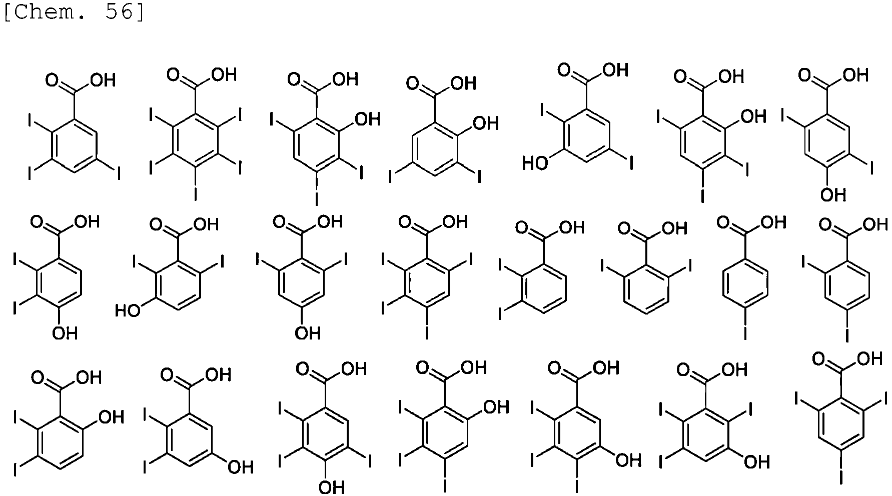

The reactions (I) to (II) may be performed, for example, in the presence of a catalyst. The catalyst is, for example, a quaternary phosphonium salt such as tetrabutylphosphonium bromide or ethyltriphenylphosphonium bromide, or a quaternary ammonium salt such as benzyltriethylammonium chloride. As the amount of the catalyst used, an appropriate amount can be selected and used from a range of 0.1 to 10 mass% with respect to the total mass of a reaction raw material used in the reaction. As the temperature and time for the reaction, for example, optimum conditions can be selected from a range of 80 to 160°C and a range of 2 to 50 hours.

The content of the polymer (A) in the resist underlayer film-forming composition is not particularly limited, and is preferably 40 mass% to 99 mass%, more preferably 45 mass% to 95 mass%, and particularly preferably 50 mass% to 90 mass% with respect to the film constituent components from the viewpoint of suitably obtaining the effect of the present invention.

In the present invention, the film constituent component means a component other than the solvent contained in the composition.

### <Solvent (B)>

The solvent (B) is not particularly limited, and may be water or an organic solvent.

Examples of the organic solvent include an alkylene glycol monoalkyl ether and a monocarboxylic acid ester of an alkylene glycol monoalkyl ether.

Examples of the alkylene group of the alkylene glycol monoalkyl ether include an alkylene group having 2 to 4 carbon atoms.

Examples of the alkyl group of the alkylene glycol monoalkyl ether include an alkyl group having 1 to 4 carbon atoms.

The number of carbon atoms of the alkylene glycol monoalkyl ether is, for example, 3 to 8.

Examples of the alkylene glycol monoalkyl ether include ethylene glycol monomethyl ether, ethylene glycol monoethyl ether, propylene glycol monomethyl ether, and propylene glycol monoethyl ether.

Examples of the alkylene group of the monocarboxylic acid ester of the alkylene glycol monoalkyl ether include an alkylene group having 2 to 4 carbon atoms.

Examples of the alkyl group of the monocarboxylic acid ester of the alkylene glycol monoalkyl ether include an alkyl group having 1 to 4 carbon atoms.

Examples of the monocarboxylic acid of the monocarboxylic acid ester of the alkylene glycol monoalkyl ether include a saturated monocarboxylic acid having 2 to 4 carbon atoms.

Examples of the saturated monocarboxylic acid having 2 to 4 carbon atoms include acetic acid, propionic acid, and butyric acid.

The number of carbon atoms of the monocarboxylic acid ester of an alkylene glycol monoalkyl ether is, for example, 5 to 10.

Examples of the monocarboxylic acid ester of an alkylene glycol monoalkyl ether include methyl cellosolve acetate, ethyl cellosolve acetate, propylene glycol monomethyl ether acetate, and propylene glycol propyl ether acetate.

Examples of other organic solvents include diethylene glycol monomethyl ether, diethylene glycol monoethyl ether, propylene glycol, toluene, xylene, methyl ethyl ketone, methyl isobutyl ketone, cyclopentanone, cyclohexanone, cycloheptanone, 4-methyl-2-pentanol, methyl 2-hydroxyisobutyrate, ethyl 2-hydroxyisobutyrate, ethyl ethoxyacetate, 2-hydroxyethyl acetate, methyl 3-methoxypropionate, ethyl 3-methoxypropionate, ethyl 3-ethoxypropionate, methyl 3-ethoxypropionate, methyl pyruvate, ethyl pyruvate, ethyl acetate, butyl acetate, ethyl lactate, butyl lactate, 2-heptanone, methoxycyclopentane, anisole, γ-butyrolactone, N-methylpyrrolidone, N,N-dimethylformamide, and N,N-dimethylacetamide.

Among these solvents (B), an alkylene glycol monoalkyl ether and a monocarboxylic acid ester of an alkylene glycol monoalkyl ether are preferred.

One type of these solvents (B) can be used alone or two or more types thereof can be used in combination.

The mass ratio of the organic solvent in the solvent (B) is not particularly limited, and is preferably 50 mass% to 100 mass%.

The content of the solvent (B) in the resist underlayer film-forming composition is not particularly limited, and is preferably 50 mass% to 99.99 mass%, more preferably 75 mass% to 99.95 mass%, and particularly preferably 90 mass% to 99.9 mass%.

### <Crosslinking agent (C)>

The crosslinking agent (C) is not particularly limited.

The crosslinking agent (C) has a structure different from that of the polymer (A).

As the crosslinking agent (C), an aminoplast crosslinking agent and a phenoplast crosslinking agent are preferred.

The aminoplast crosslinking agent is an addition condensate of a compound having an amino group, such as melamine or guanamine, and formaldehyde.

The phenoplast crosslinking agent is an addition condensate of a compound having a phenolic hydroxy group and formaldehyde.

Examples of the crosslinking agent (C) include a compound having two or more structures shown below.

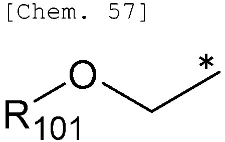

In the structure, R₁₀₁ represents a hydrogen atom, an alkyl group having 1 to 4 carbon atoms, or an alkoxyalkyl group having 2 to 6 carbon atoms. * represents a bond.

The bond is bonded to, for example, a nitrogen atom, a carbon atom constituting an aromatic hydrocarbon ring, or the like.

As R₁₀₁, a hydrogen atom, a methyl group, an ethyl group, or a group represented by the following structure is preferred.

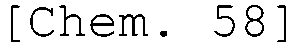

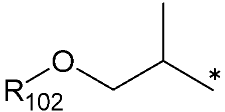

In the structure, R₁₀₂ represents a hydrogen atom, a methyl group, or an ethyl group. * represents a bond.

The crosslinking agent (C) is preferably a melamine compound, a guanamine compound, a glycoluril compound, a urea compound, or a compound having a phenolic hydroxy group. One type of these can be used alone or two or more types thereof can be used in combination.

Examples of the melamine compound include hexamethylolmelamine, hexamethoxymethylmelamine, a compound in which 1 to 6 methylol groups of hexamethylolmelamine are methoxymethylated or a mixture thereof, hexamethoxyethylmelamine, hexaacyloxymethylmelamine, and a compound in which 1 to 6 methylol groups of hexamethylolmelamine are acyloxymethylated or a mixture thereof.

Examples of the guanamine compound include tetramethylolguanamine, tetramethoxymethylguanamine, a compound in which 1 to 4 methylol groups of tetramethylolguanamine are methoxymethylated or a mixture thereof, tetramethoxyethylguanamine, tetraacyloxyguanamine, and a compound in which 1 to 4 methylol groups of tetramethylolguanamine are acyloxymethylated or a mixture thereof.

Examples of the glycoluril compound include tetramethylolglycoluril, tetramethoxyglycoluril, tetramethoxymethylglycoluril, a compound in which 1 to 4 methylol groups of tetramethylolglycoluril are methoxymethylated or a mixture thereof, and a compound in which 1 to 4 methylol groups of tetramethylolglycoluril are acyloxymethylated or a mixture thereof.

The glycoluril compound may be, for example, a glycoluril derivative represented by formula (1E) below.

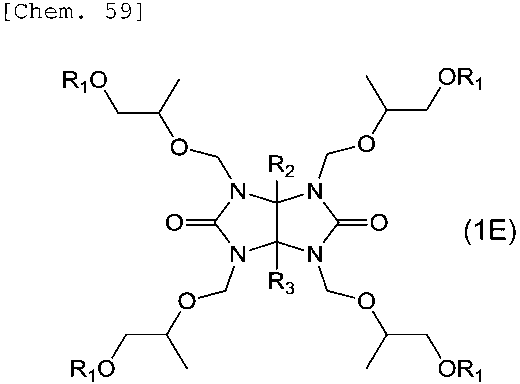

In formula (1E), four R₁'s each independently represent a methyl group or an ethyl group, and R₂ and R₃ each independently represent a hydrogen atom, an alkyl group having 1 to 4 carbon atoms, or a phenyl group.

Examples of the glycoluril derivative represented by formula (1E) include compounds represented by formulae (1E-1) to (1E-6) below.

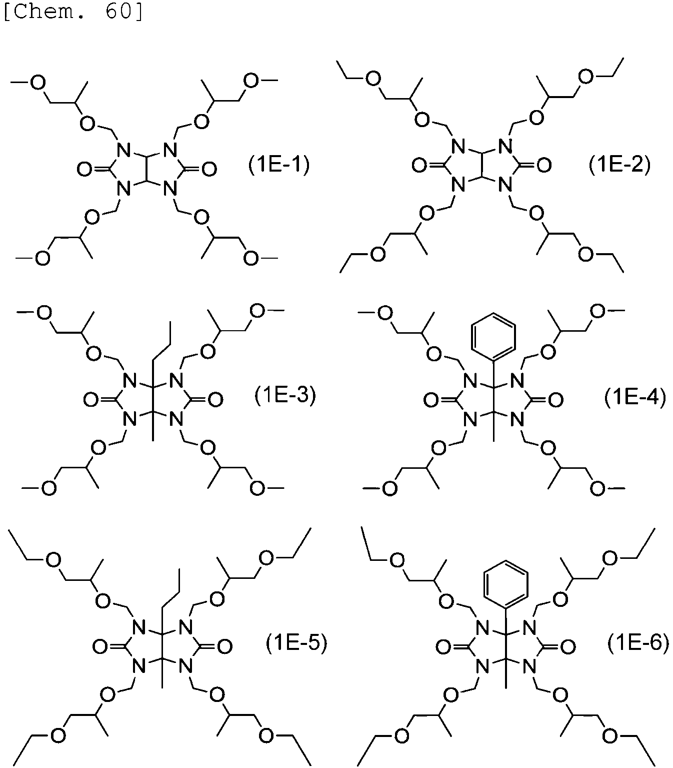

The glycoluril derivative represented by formula (1E) is obtained, for example, by a reaction of a glycoluril derivative represented by formula (2E) below with at least one compound represented by formula (3d) below.

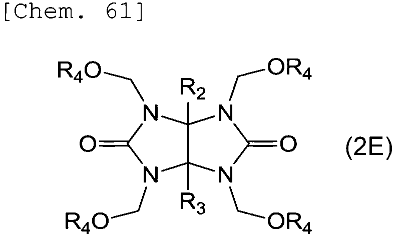

In formula (2E), R₂ and R₃ each independently represent a hydrogen atom, an alkyl group having 1 to 4 carbon atoms, or a phenyl group, and R₄'s each independently represent an alkyl group having 1 to 4 carbon atoms.

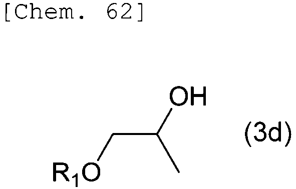

In formula (3d), R₁ represents a methyl group or an ethyl group.

Examples of the glycoluril derivative represented by formula (2E) include compounds represented by formulae (2E-1) to (2E-4) below. Further, examples of the compound represented by formula (3d) include compounds represented by formulae (3d-1) and (3d-2) below.

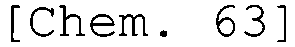

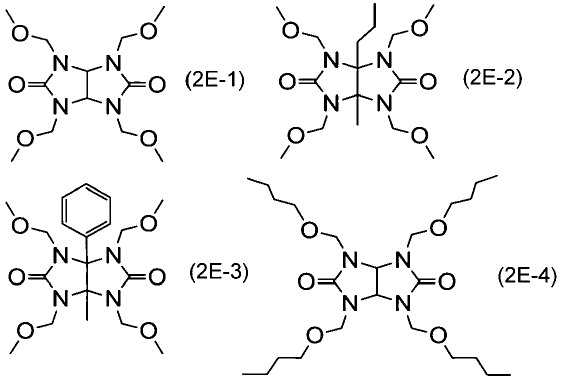

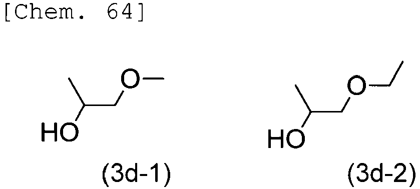

Examples of the urea compound include tetramethylolurea, tetramethoxymethylurea, a compound in which 1 to 4 methylol groups of tetramethylolurea are methoxymethylated or a mixture thereof, and tetramethoxyethylurea.

Examples of the compound having a phenolic hydroxy group include a compound represented by formula (G-1) or (G-2) below.

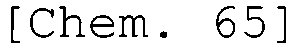

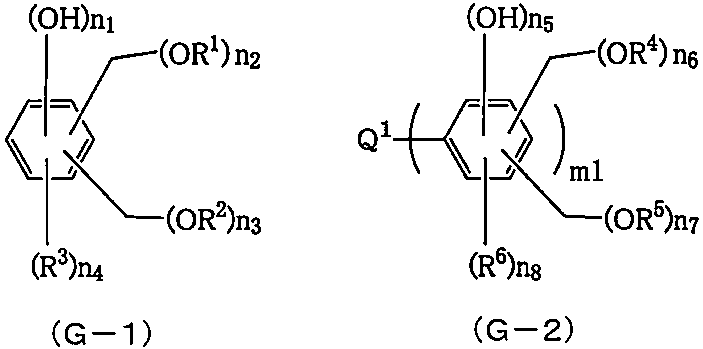

In formulae (G-1) and (G-2), Q¹ represents a single bond or an m1-valent organic group.

R¹ and R⁴ each represent an alkyl group having 2 to 10 carbon atoms or an alkyl group having 2 to 10 carbon atoms and having an alkoxy group having 1 to 10 carbon atoms.

R² and R⁵ each represent a hydrogen atom or a methyl group.

R³ and R⁶ each represent an alkyl group having 1 to 10 carbon atoms or an aryl group having 6 to 40 carbon atoms.

n₁ represents an integer that meets 1 ≤ n₁ ≤ 3, n₂ represents an integer that meets 2 ≤ n₂ ≤ 5, n₃ represents an integer that meets 0 ≤ n₃ ≤ 3, n₄ represents an integer that meets 0 ≤ n₄ ≤ 3, and an integer that meets 3 ≤ (n₁ + n₂ + n₃ + n₄) ≤ 6.

n₅ represents an integer that meets 1 ≤ n₅ ≤ 3, n₆ represents an integer that meets 1 ≤ n₆ ≤ 4, n₇ represents an integer that meets 0 ≤ n₇ ≤ 3, n₈ represents an integer that meets 0 ≤ n₈ ≤ 3, and an integer that meets 2 ≤ (n₅ + n₆ + n₇ + n₈) ≤ 5.

m1 represents an integer of 2 to 10.

Examples of the compound having a phenolic hydroxy group include a compound represented by formula (G-3) or (G-4) below.

The compound represented by formula (G-1) or formula (G-2) may be obtained by a reaction of a compound represented by formula (G-3) or formula (G-4) below with a hydroxyl group-containing ether compound or an alcohol having 2 to 10 carbon atoms.

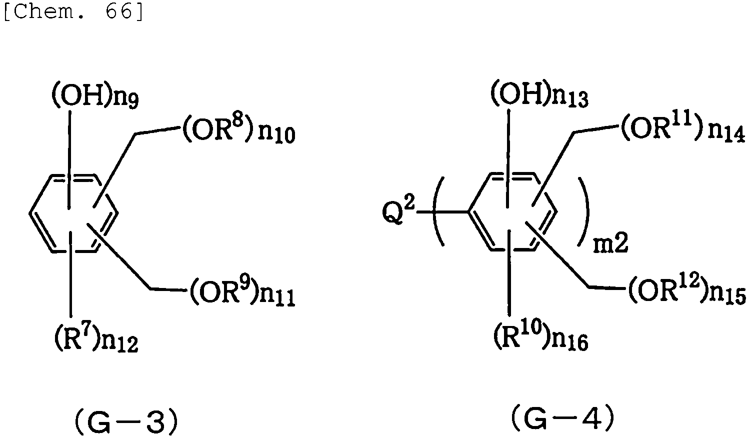

In formula (G-3) and formula (G-4), Q² represents a single bond or an m2-valent organic group.

R⁸, R⁹, R¹¹, and R¹² each represent a hydrogen atom or a methyl group.

R⁷ and R¹⁰ each represent an alkyl group having 1 to 10 carbon atoms or an aryl group having 6 to 40 carbon atoms.

n₉ represents an integer that meets 1 ≤ n₉ ≤ 3, n₁₀ represents an integer that meets 2 ≤ n₁₀ ≤ 5, n₁₁ represents an integer that meets 0 ≤ n₁₁ ≤ 3, n₁₂ represents an integer that meets 0 ≤ n₁₂ ≤ 3, and an integer that meets 3 ≤ (n₉ + n₁₀ + n₁₁ + n₁₂) ≤ 6.

n₁₃ represents an integer that meets 1 ≤ n₁₃ ≤ 3, n₁₄ represents an integer that meets 1 ≤ n₁₄ ≤ 4, n₁₅ represents an integer that meets 0 ≤ n₁₅ ≤ 3, and n₁₆ represents an integer that meets 0 ≤ n₁₆ ≤ 3, and an integer that meets 2 ≤ (n₁₃ + n₁₄ + n₁₅ + n₁₆) ≤ 5.

m2 represents an integer of 2 to 10.

Examples of the m2-valent organic group of Q² include an m2-valent organic group having 1 to 4 carbon atoms.

Examples of the compound represented by formula (G-1) or formula (G-2) include the following compounds.

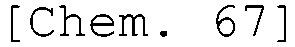

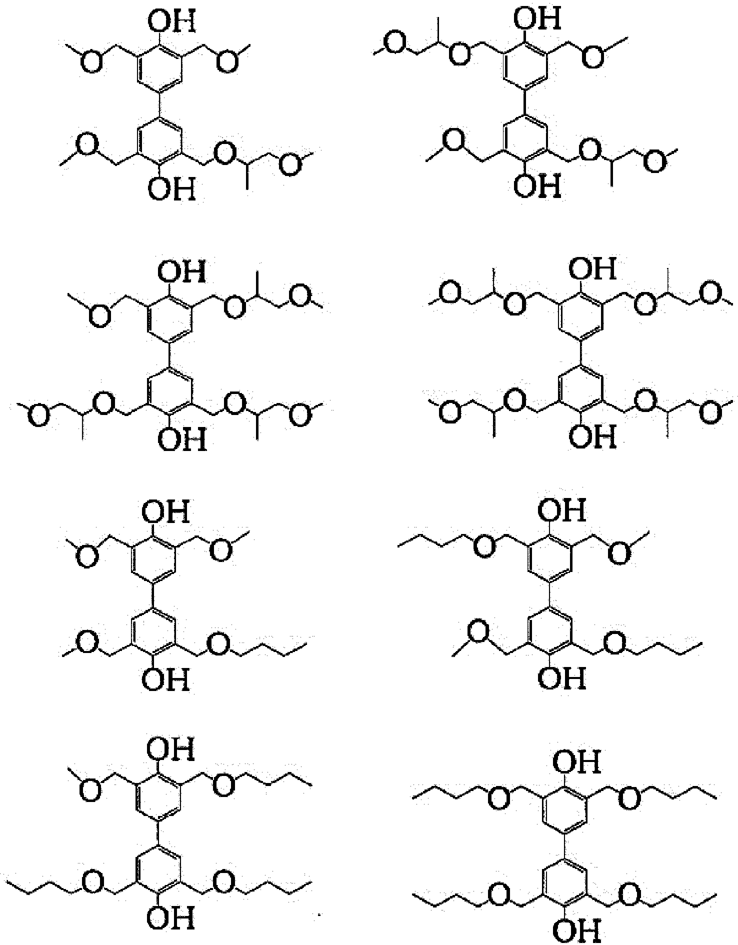

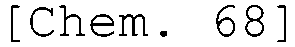

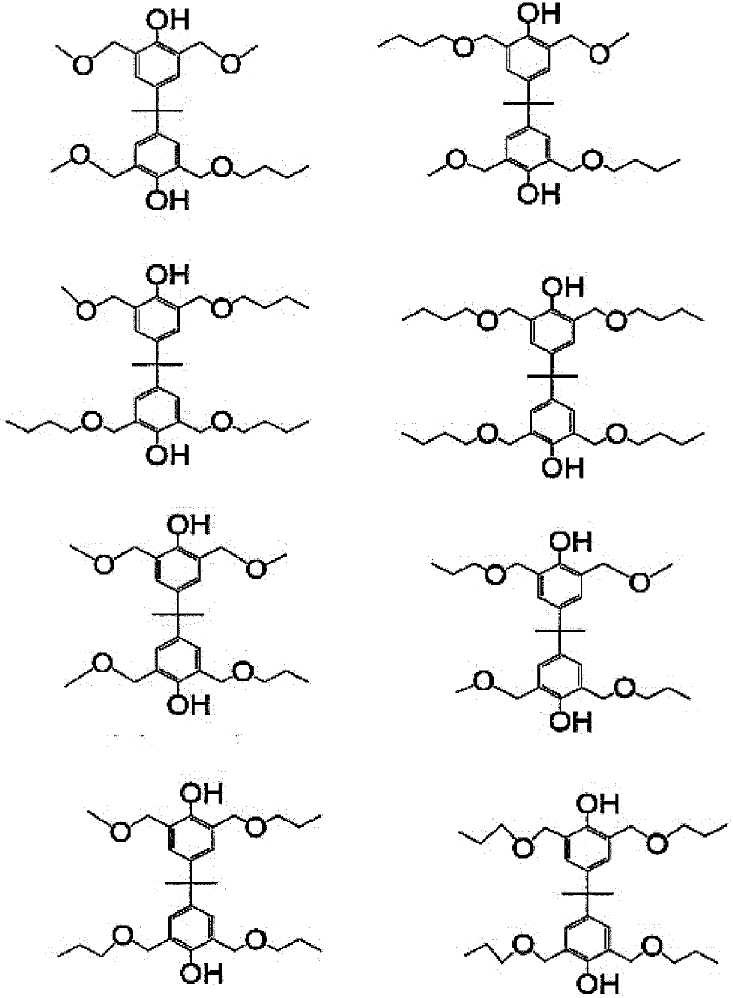

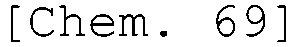

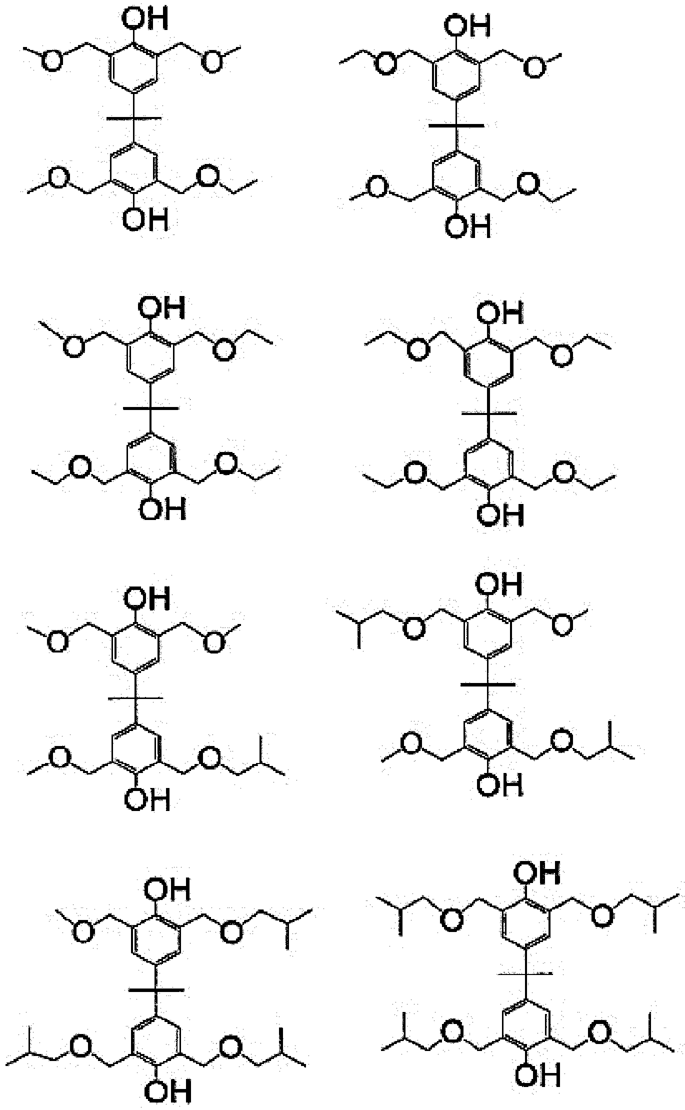

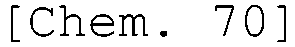

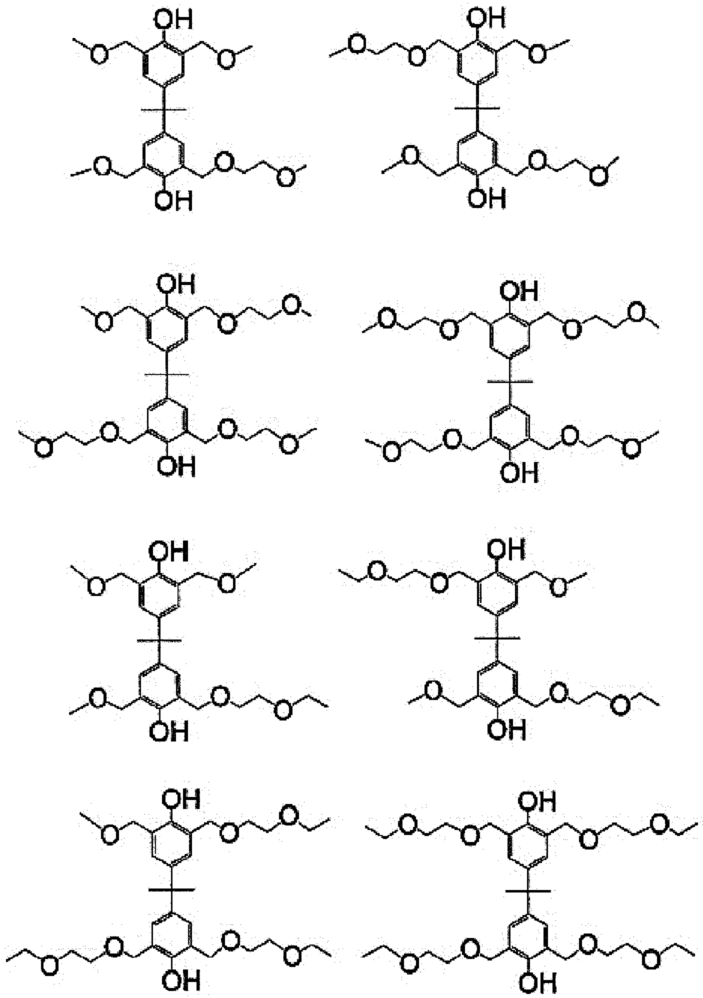

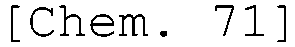

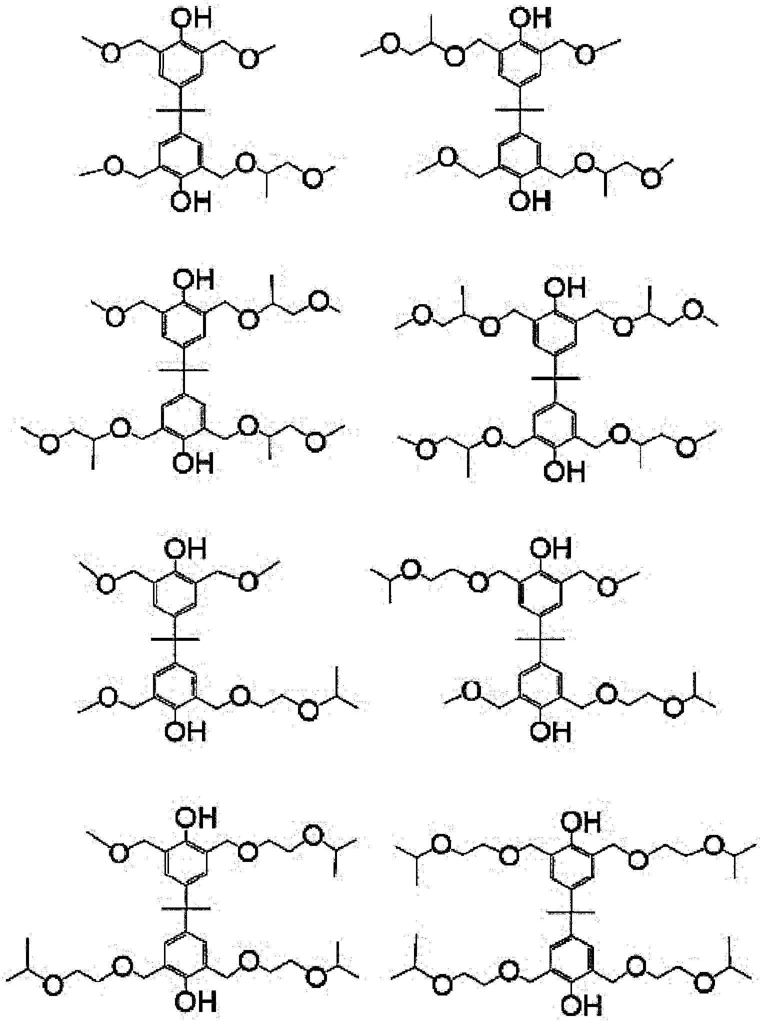

Examples of the compound represented by formula (G-3) or formula (G-4) include the following compounds.

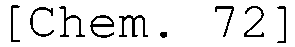

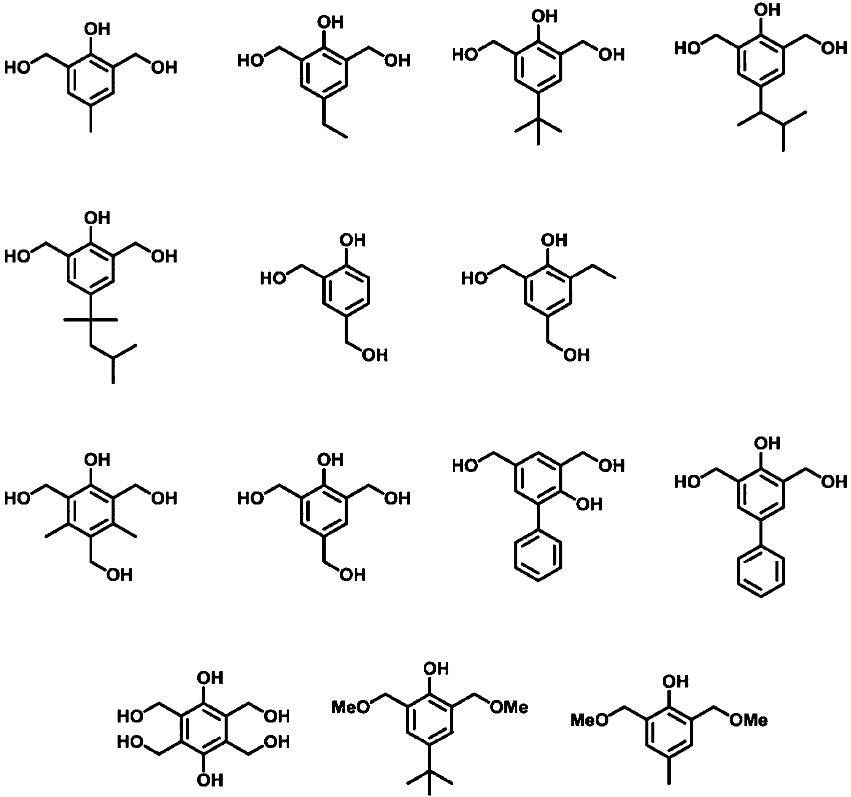

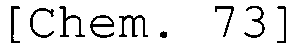

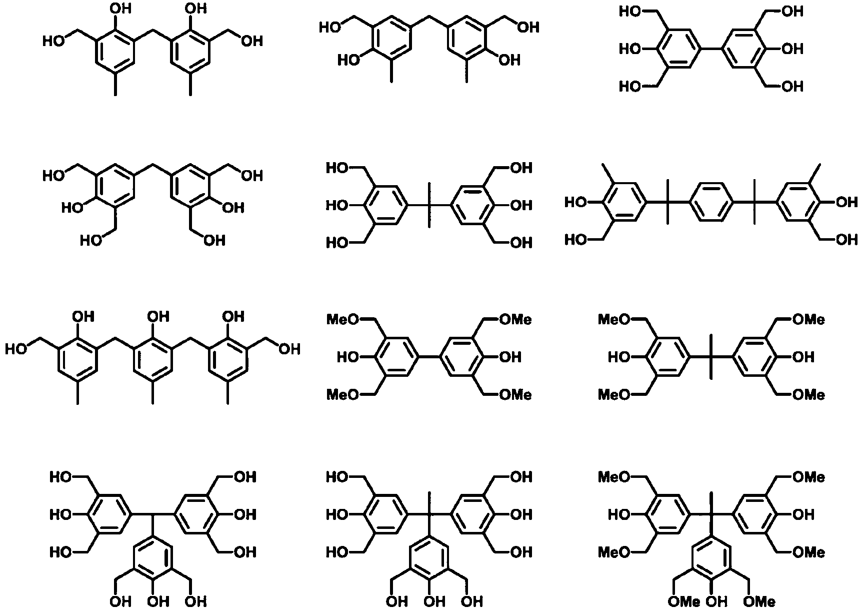

The compounds are available as products of Asahi Yukizai Corporation and Honshu Chemical Industry Co., Ltd. Examples of the product include TMOM-BP (trade name) manufactured by Asahi Yukizai Corporation.

Among the compounds, the glycoluril compound is preferred. Specifically, tetramethylol glycoluril, tetramethoxy glycoluril, tetramethoxymethyl glycoluril, a compound in which 1 to 4 methylol groups of tetramethylol glycoluril are methoxymethylated or a mixture thereof, and a compound in which 1 to 4 methylol groups of tetramethylol glycoluril are acyloxymethylated or a mixture thereof are preferred, and tetramethoxymethyl glycoluril is more preferred.

The molecular weight of the crosslinking agent (C) is not particularly limited, and is preferably 500 or less.

The content of the crosslinking agent (C) in the resist underlayer film-forming composition is not particularly limited, and is, for example, 1 mass% to 70 mass%, and preferably 5 mass% to 60 mass% with respect to the polymer (A).

### <Curing catalyst (D)>

As the curing catalyst (D) contained as an optional component in the resist underlayer film-forming composition, both a thermal acid generator and a photoacid generator can be used, and a thermal acid generator is preferably used.

Examples of the thermal acid generator include sulfonic acid compounds and carboxylic acid compounds such as p-toluenesulfonic acid, trifluoromethanesulfonic acid, pyridinium-p-toluenesulfonate (pyridinium-p-toluenesulfonic acid), pyridinium phenolsulfonate, pyridinium p-hydroxybenzenesulfonate (p-phenolsulfonic acid pyridinium salt), pyridinium-trifluoromethanesulfonate, salicylic acid, camphorsulfonic acid, 5-sulfosalicylic acid, 4-chlorobenzenesulfonic acid, 4-hydroxybenzenesulfonic acid, benzenedisulfonic acid, 1-naphthalenesulfonic acid, citric acid, benzoic acid, hydroxybenzoic acid, N-methylmorpholine-p-toluenesulfonate, N-methylmorpholine-p-hydroxybenzenesulfonate, and N-methylmorpholine-5-sulfosalicylate.

Examples of the photoacid generator include an onium salt compound, a sulfonimide compound, and a disulfonyl diazomethane compound.

Examples of the onium salt compound include iodonium salt compounds such as diphenyliodonium hexafluorophosphate, diphenyliodonium trifluoromethanesulfonate, diphenyliodonium nonafluoronormalbutanesulfonate, diphenyliodonium perfluoronormaloctanesulfonate, diphenyliodonium camphorsulfonate, bis(4-tert-butylphenyl)iodonium camphorsulfonate, and bis(4-tert-butylphenyl)iodonium trifluoromethanesulfonate; and sulfonium salt compounds such as triphenylsulfonium hexafluoroantimonate, triphenylsulfonium nonafluoronormalbutanesulfonate, triphenylsulfonium camphorsulfonate, and triphenylsulfonium trifluoromethanesulfonate.

Examples of the sulfonimide compound include N-(trifluoromethanesulfonyloxy)succinimide, N-(nonafluoronormalbutanesulfonyloxy)succinimide, N-(camphorsulfonyloxy)succinimide, and N-(trifluoromethanesulfonyloxy)naphthalimide.

Examples of the disulfonyl diazomethane compound include bis(trifluoromethylsulfonyl)diazomethane, bis(cyclohexylsulfonyl)diazomethane, bis(phenylsulfonyl)diazomethane, bis(p-toluenesulfonyl)diazomethane, bis(2,4-dimethylbenzenesulfonyl)diazomethane, and methylsulfonyl-p-toluenesulfonyl diazomethane.

As the curing catalyst (D), only one type can be used, or two or more types can be used in combination.

In a case where the curing catalyst (D) is used, the content ratio of the curing catalyst (D) is, for example, 0.1 mass% to 50 mass%, and preferably 1 mass% to 30 mass% with respect to the crosslinking agent (C).

### <Other components>

To the resist underlayer film-forming composition, a surfactant can be further added in order to further improve the coatability against surface unevenness without generating a pinhole, a striation, and the like.

Examples of the surfactant include linear or branched alkylbenzenesulfonic acids (such as dodecylbenzenesulfonic acid); polyoxyethylene alkyl ethers such as polyoxyethylene lauryl ether, polyoxyethylene stearyl ether, polyoxyethylene cetyl ether, and polyoxyethylene oleyl ether; polyoxyethylene alkyl aryl ethers such as polyoxyethylene octylphenol ether and polyoxyethylene nonylphenol ether; polyoxyethylene/polyoxypropylene block copolymers; sorbitan fatty acid esters such as sorbitan monolaurate, sorbitan monopalmitate, sorbitan monostearate, sorbitan monooleate, sorbitan trioleate, and sorbitan tristearate; nonionic surfactants of polyoxyethylene sorbitan fatty acid esters and the like such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate; fluorine-based surfactants such as EFTOP EF301, EF303, and EF352 (manufactured by TOHKEM PRODUCTS Corporation, trade names); MEGAFACE F171, F173, and R-30 (manufactured by DIC Corporation, trade names); Fluorad FC430 and FC431 (manufactured by Sumitomo 3M Limited, trade names); AsahiGuard AG710 and Surflon S-382, SC101, SC102, SC103, SC104, SC105, and SC106 (manufactured by AGC Corporation, trade names); and organosiloxane polymer KP341 (manufactured by Shin-Etsu Chemical Co., Ltd.).

The blending amount of such a surfactant is usually 2.0 mass% or less, and preferably 1.0 mass% or less with respect to the total solid content of the resist underlayer film-forming composition.

These surfactants may be added alone, or two or more types thereof can also be added in combination.

The amount of the solid content in the resist underlayer film-forming composition of the present invention, that is, the components excluding the solvent is, for example, 0.01 mass% to 10 mass%.

### (Resist underlayer film)

A resist underlayer of the present invention is a cured product of the above-described resist underlayer film-forming composition.

The resist underlayer film can be produced, for example, by applying the above-described resist underlayer film-forming composition onto a semiconductor substrate and baking the composition.

Examples of the semiconductor substrate to which the resist underlayer film-forming composition is applied include a silicon wafer, a germanium wafer, and a semiconductor wafer formed of a compound such as gallium arsenide, indium phosphide, gallium nitride, indium nitride, or aluminum nitride.

In the case of using the semiconductor substrate having a surface on which an inorganic film is formed, the inorganic film is formed by, for example, an atomic layer deposition (ALD) method, a chemical vapor deposition (CVD) method, a reactive sputtering method, an ion plating method, a vacuum deposition method, or a spin coating method (spin-on-glass, SOG). Examples of the inorganic film include a polysilicon film, a silicon oxide film, a silicon nitride film, a boro-phospho silicate glass (BPSG) film, a titanium nitride film, a titanium nitride oxide film, a tungsten film, a gallium nitride film, and a gallium arsenide film.

The resist underlayer film-forming composition of the present invention is applied onto such a semiconductor substrate with an appropriate application method using a spinner, a coater, or the like. Thereafter, baking is performed using a heating unit such as a hot plate to form a resist underlayer film. The baking conditions are appropriately selected from a baking temperature of 100°C to 400°C and a baking time of 0.3 minutes to 60 minutes. Preferably, the baking temperature is 120°C to 350°C and the baking time is 0.5 minutes to 30 minutes. More preferably, the baking temperature is 150°C to 300°C and the baking time is 0.8 minutes to 10 minutes.

The film thickness of the resist underlayer film is, for example, 0.001 µm (1 nm) to 10 µm, 0.002 µm (2 nm) to 1 µm, 0.005 µm (5 nm) to 0.5 µm (500 nm), 0.001 µm (1 nm) to 0.05 µm (50 nm), 0.002 µm (2 nm) to 0.05 µm (50 nm), 0.003 µm (3 nm) to 0.05 µm (50 nm), 0.004 µm (4 nm) to 0.05 µm (50 nm), 0.005 µm (5 nm) to 0.05 µm (50 nm), 0.003 µm (3 nm) to 0.03 µm (30 nm), 0.003 µm (3 nm) to 0.02 µm (20 nm), 0.005 µm (5 nm) to 0.02 µm (20 nm), 0.005 µm (5 nm) to 0.02 µm (20 nm), 0.003 µm (3 nm) to 0.01 µm (10 nm), 0.005 µm (5 nm) to 0.01 µm (10 nm), 0.003 µm (3 nm) to 0.006 µm (6 nm), or 0.005 µm (5 nm). The lower limit of the film thickness is, for example, 0.5 nm, 1 nm, 2 nm, 3 nm, 4 nm, or 5 nm. The upper limit is, for example, 20 nm, 19 nm, 18 nm, 17 nm, 16 nm, 15 nm, 14 nm, 13 nm, 12 nm, 11 nm, 10 nm, 9 nm, 8 nm, 7 nm, 6 nm, 5 nm, 4 nm, 3 nm, or 2 nm.

The method for measuring the film thickness of the resist underlayer film in the present description is as follows.
· Measurement device name: Ellipsometric film thickness measurement device RE-3100 (SCREEN Holdings Co., Ltd.)
· Single wavelength ellipsometer (SWE) mode
· Arithmetic average of measurements at 8 points (for example, measurement is made at 8 points at intervals of 1 cm in X direction of wafer)

### (Laminate)

A laminate of the present invention includes a semiconductor substrate and the resist underlayer film of the present invention.

Examples of the semiconductor substrate include the semiconductor substrates described above.

The resist underlayer film is disposed on the semiconductor substrate, for example.

### (Semiconductor element producing method and pattern forming method)

The semiconductor element producing method of the present invention includes at least the following steps.
· a step of forming a resist underlayer film on a semiconductor substrate using the resist underlayer film-forming composition of the present invention
· a step of forming a resist film on the resist underlayer film

The pattern forming method of the present invention includes at least the following steps.
· a step of forming a resist underlayer film on a semiconductor substrate using the resist underlayer film-forming composition of the present invention
· a step of forming a resist film on the resist underlayer film
· a step of irradiating the resist film with light or an electron beam, and then developing the resist film to obtain a resist pattern
· a step of etching the resist underlayer film using the resist pattern as a mask

Usually, a resist layer is formed on the resist underlayer film.

The film thickness of the resist layer is, for example, 3,000 nm or less, 2,000 nm or less, 1,800 nm or less, 1,500 nm or less, or 1,000 nm or less. The lower limit is 100 nm, 80 nm, 50 nm, 30 nm, 20 nm, or 10 nm.

The resist film formed on the resist underlayer film by a known method (for example, application and baking of a resist composition) is not particularly limited as long as it responds to light or an electron beam (EB) used for irradiation. Both a negative photoresist and a positive photoresist can be used.

In the present description, a resist that responds to an EB is also referred to as a photoresist.

Examples of the photoresist include a positive photoresist made of a novolac resin and 1,2-naphthoquinonediazide sulfonic acid ester, a chemically amplified photoresist made of a binder having a group, which is decomposed by an acid to increase the alkali dissolution rate, and a photoacid generator, a chemically amplified photoresist made of a low molecular compound, which is decomposed by an acid to increase the alkali dissolution rate of the photoresist, an alkali-soluble binder, and a photoacid generator, a chemically amplified photoresist made of a binder having a group, which is decomposed by an acid to increase the alkali dissolution rate, a low molecular compound, which is decomposed by an acid to increase the alkali dissolution rate of the photoresist, and a photoacid generator, and a resist containing a metal element. Examples thereof include V146G (trade name) manufactured by JSR Corporation, APEX-E (trade name) manufactured by Shipley, PAR710 (trade name) manufactured by SUMITOMO CHEMICAL COMPANY, LIMITED, and AR2772 and SEPR430 (trade names) manufactured by Shin-Etsu Chemical Co., Ltd. In addition, examples thereof include fluorine atom-containing polymer-based photoresists as described in Proc. SPIE, Vol. 3999, 330-334 (2000), Proc. SPIE, Vol. 3999, 357-364 (2000), and Proc. SPIE, Vol. 3999, 365-374 (2000).

Furthermore, so-called resist compositions and metal-containing resist compositions can be used which include resist compositions, radiation-sensitive resin compositions, and high-resolution patterning compositions based on organometallic solutions, described in WO 2019/188595, WO 2019/187881, WO 2019/187803, WO 2019/167737, WO 2019/167725, WO 2019/187445, WO 2019/167419, WO 2019/123842, WO 2019/054282, WO 2019/058945, WO 2019/058890, WO 2019/039290, WO 2019/044259, WO 2019/044231, WO 2019/026549, WO 2018/193954, WO 2019/172054, WO 2019/021975, WO 2018/230334, WO 2018/194123, JP 2018-180525, WO 2018/190088, JP 2018-070596, JP 2018-028090, JP 2016-153409, JP 2016-130240, JP 2016-108325, JP 2016-047920, JP 2016-035570, JP 2016-035567, JP 2016-035565, JP 2019-101417, JP 2019-117373, JP 2019-052294, JP 2019-008280, JP 2019-008279, JP 2019-003176, JP 2019-003175, JP 2018-197853, JP 2019-191298, JP 2019-061217, JP 2018-045152, JP 2018-022039, JP 2016-090441, JP 2015-10878, JP 2012-168279, JP 2012-022261, JP 2012-022258, JP 2011-043749, JP 2010-181857, JP 2010-128369, WO 2018/031896, JP 2019-113855, WO 2017/156388, WO 2017/066319, JP 2018-41099, WO 2016/065120, WO 2015/026482, JP 2016-29498, JP 2011-253185, and the like, but the resist compositions are not limited thereto.

Examples of the resist composition include the following compositions.

An actinic ray-sensitive or radiation-sensitive resin composition containing a resin A having a repeating unit having an acid-decomposable group in which a polar group is protected by a protecting group to be removed by an action of an acid, and a compound represented by general formula (121) below.

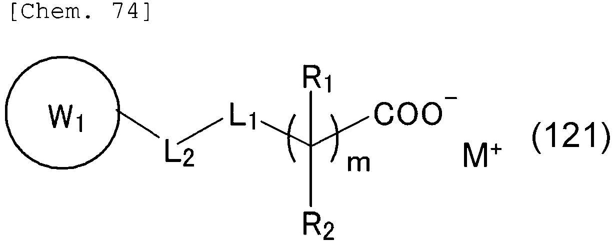

In general formula (121), m represents an integer of 1 to 6.

R₁ and R₂ each independently represent a fluorine atom or a perfluoroalkyl group.

L₁ represents -O-, -S-, -COO-, -SO₂-, or -SO₃-.

L₂ represents an alkylene group which may have a substituent, or a single bond.

W₁ represents a cyclic organic group which may have a substituent.

M⁺ represents a cation.

A metal-containing film-forming composition for extreme ultraviolet or electron lithography, containing a compound having a metal-oxygen covalent bond and a solvent, in which metal elements included in the compound belong to periods 3 to 7 of groups 3 to 15 in the periodic table.

A radiation-sensitive resin composition that contains a polymer having a first structural unit represented by formula (31) below and a second structural unit represented by formula (32) below and containing an acid-dissociable group, and that contains an acid generator. 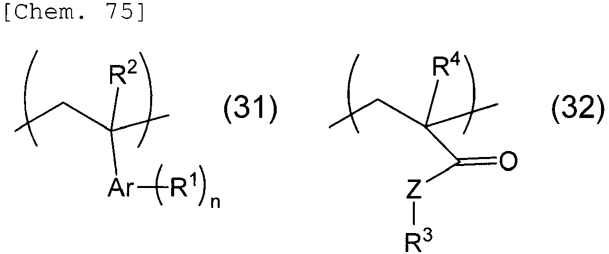 In formula (31), Ar is a group obtained by removing (n + 1) hydrogen atoms from an arene having 6 to 20 carbon atoms, R¹ is a hydroxy group, a sulfanyl group, or a monovalent organic group having 1 to 20 carbon atoms, n is an integer of 0 to 11, when n is 2 or more, a plurality of R¹'s are identical or different, and R² is a hydrogen atom, a fluorine atom, a methyl group, or a trifluoromethyl group. In formula (32), R³ is a monovalent group having 1 to 20 carbon atoms and containing the acid-dissociable group, Z is a single bond, an oxygen atom, or a sulfur atom, and R⁴ is a hydrogen atom, a fluorine atom, a methyl group, or a trifluoromethyl group.

A resist composition that contains a resin (A1) including a structural unit having a cyclic carbonate structure, a structural unit represented by the following formula, and a structural unit having an acid-unstable group, and that contains an acid generator.

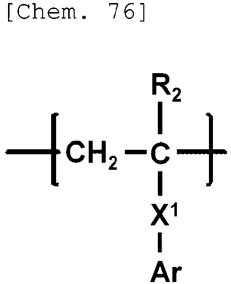

In the formula,
R² represents an alkyl group which has 1 to 6 carbon atoms and may have a halogen atom or represents a hydrogen atom or a halogen atom, X¹ represents a single bond, -CO-O-*, or -CO-NR⁴-*, * represents a bond with -Ar, R⁴ represents a hydrogen atom or an alkyl group having 1 to 4 carbon atoms, and Ar represents an aromatic hydrocarbon group which has 6 to 20 carbon atoms and may have one or more groups selected from the group consisting of a hydroxy group and a carboxyl group.

Examples of the resist film are as follows.

A resist film including a base resin including a repeating unit represented by formula (a1) below and/or a repeating unit represented by formula (a2) below, and a repeating unit that generates an acid bonded to a polymer main chain by exposure.

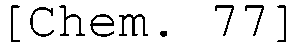

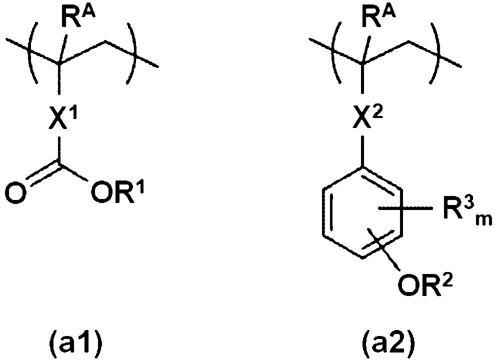

In formula (a1) and formula (a2), R^{A}'s are each independently a hydrogen atom or a methyl group, R¹ and R² are each independently a tertiary alkyl group having 4 to 6 carbon atoms, R³'s are each independently a fluorine atom or a methyl group, m is an integer of 0 to 4, X¹ is a single bond, a phenylene group, a naphthylene group, or a linking group having 1 to 12 carbon atoms and including at least one type selected from an ester bond, a lactone ring, a phenylene group, and a naphthylene group, and X² is a single bond, an ester bond, or an amide bond.

Examples of the resist material are as follows.

A resist material containing a polymer having a repeating unit represented by formula (b1) or formula (b2) below.

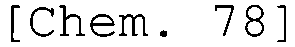

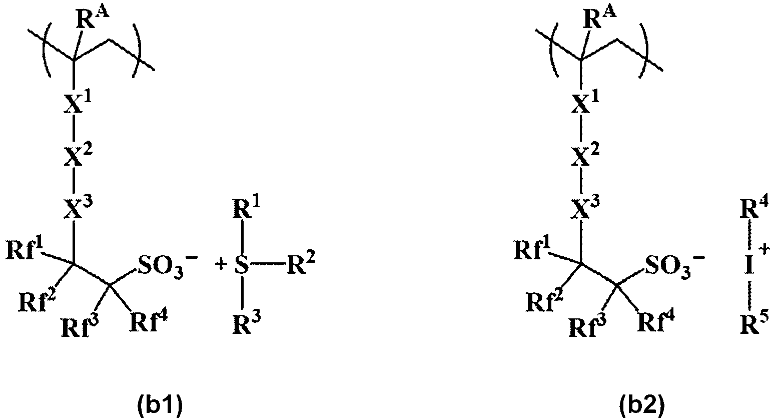

In formula (b1) and formula (b2), R^{A} is a hydrogen atom or a methyl group, X¹ is a single bond or an ester group, X² is a linear, branched, or cyclic alkylene group having 1 to 12 carbon atoms or an arylene group having 6 to 10 carbon atoms, and some of methylene groups included in the alkylene group may be substituted with an ether group, an ester group, or a lactone ring-containing group, and at least one hydrogen atom included in X² is substituted with a bromine atom, X³ is a single bond, an ether group, an ester group, or a linear, branched, or cyclic alkylene group having 1 to 12 carbon atoms, and some of methylene groups included in the alkylene group may be substituted with an ether group or an ester group, Rf¹ to Rf⁴ are each independently a hydrogen atom, a fluorine atom, or a trifluoromethyl group, and at least one of Rf¹ to Rf⁴ is a fluorine atom or a trifluoromethyl group, Rf¹ and Rf² may be combined to form a carbonyl group, R¹ to R⁵ are each independently a linear, branched, or cyclic alkyl group having 1 to 12 carbon atoms, a linear, branched, or cyclic alkenyl group having 2 to 12 carbon atoms, an alkynyl group having 2 to 12 carbon atoms, an aryl group having 6 to 20 carbon atoms, an aralkyl group having 7 to 12 carbon atoms, or an aryloxyalkyl group having 7 to 12 carbon atoms, and some or all of hydrogen atoms of these groups may be substituted with a hydroxy group, a carboxy group, a halogen atom, an oxo group, a cyano group, an amide group, a nitro group, a sultone group, a sulfone group, or a sulfonium salt-containing group, and some of methylene groups included in these groups may be substituted with an ether group, an ester group, a carbonyl group, a carbonate group, or a sulfonic acid ester group, and R¹ and R² may be bonded to form a ring together with a sulfur atom to which R¹ and R² are bonded.

A resist material containing a base resin including a polymer having a repeating unit represented by formula (a) below.

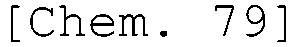

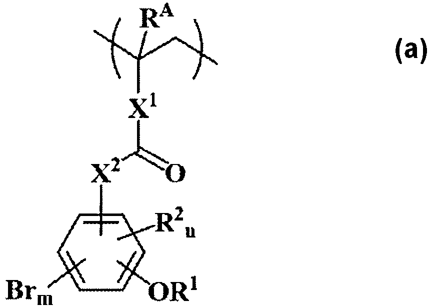

In formula (a), R^{A} is a hydrogen atom or a methyl group, R¹ is a hydrogen atom or an acid-unstable group, R² is a linear, branched, or cyclic alkyl group having 1 to 6 carbon atoms or a halogen atom other than bromine, X¹ is a single bond, a phenylene group, or a linear, branched, or cyclic alkylene group which has 1 to 12 carbon atoms and may include an ester group or a lactone ring, X² is -O-, - O-CH₂-, or -NH-, m is an integer of 1 to 4, and u is an integer of 0 to 3, provided that m + u is an integer of 1 to 4.

A resist composition generating an acid by exposure and having solubility in a developer changed by an action of an acid, the resist composition containing
a base material component (A) that has a solubility in a developer changed by an action of an acid, and a fluorine additive component (F) that exhibits decomposability in an alkaline developer,
in which the fluorine additive component (F) contains a fluororesin component (F1) that has a constituent unit (f1) containing a base-dissociable group and a constituent unit (f2) containing a group represented by general formula (f2-r-1) below.

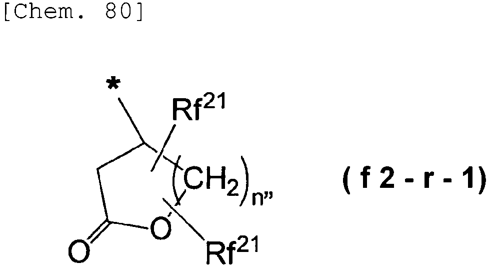

In formula (f2-r-1), Rf²¹'s each independently are a hydrogen atom, an alkyl group, an alkoxy group, a hydroxy group, a hydroxyalkyl group, or a cyano group, n" is an integer of 0 to 2, and * is a bond.

The constituent unit (f1) includes a constituent unit represented by general formula (f1-1) below or a constituent unit represented by general formula (f1-2) below.

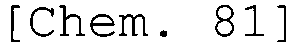

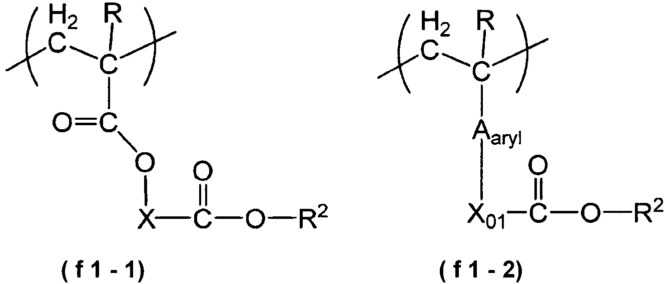

In formulae (f1-1) and (f1-2), R's are each independently a hydrogen atom, an alkyl group having 1 to 5 carbon atoms, or a halogenated alkyl group having 1 to 5 carbon atoms, X is a divalent linking group not having an acid-dissociable site, A_{aryl} is a divalent aromatic ring group which may have a substituent, X₀₁ is a single bond or a divalent linking group, and R²'s each independently are an organic group having a fluorine atom.

Examples of the coating, the coating solution, and the coating composition are as follows.

A coating including a metal oxo-hydroxo network having an organic ligand via a metal carbon bond and/or a metal carboxylate bond.

An inorganic oxo/hydroxo-based composition.

A coating solution containing: an organic solvent; a first organometallic composition represented by the formula R_{z}SnO_{(2-(z/2)-(x/2))}(OH)ₓ (here, 0 < z ≤ 2 and 0 < (z + x) ≤ 4), the formula R'ₙSnX₄₋ₙ (here, n = 1 or 2), or a mixture thereof, in which R and R' independently represent a hydrocarbyl group having 1 to 31 carbon atoms and X represents a ligand having a hydrolysable bond to Sn or a combination of such ligands; and a hydrolysable metal compound represented by the formula MX'ᵥ (here, M represents a metal selected from groups 2 to 16 in the periodic table, v is a number of v = 2 to 6, and X' represents a ligand having a hydrolysable M-X bond or a combination of such ligands).

A coating solution containing an organic solvent and a first organometallic compound represented by the formula RSnO_{(3/2-x/2)}(OH)ₓ (in the formula, 0 < x < 3), in which the solution contains about 0.0025 M to about 1.5 M tin, R represents an alkyl group or a cycloalkyl group having 3 to 31 carbon atoms, and the alkyl group or the cycloalkyl group is bonded to tin at a secondary or tertiary carbon atom.

An inorganic pattern forming precursor aqueous solution including a mixture of water, a metal suboxide cation, a polyatomic inorganic anion, and a radiation-sensitive ligand containing a peroxide group.

Irradiation with light or an electron beam is performed, for example, through a mask (reticle) for formation of a predetermined pattern. For example, an i-line, a KrF excimer laser, an ArF excimer laser, an extreme ultraviolet ray (EUV), or an electron beam (EB) is used. The resist underlayer film-forming composition of the present invention is preferably applied for electron beam (EB) or extreme ultraviolet (EUV: 13.5 nm) irradiation, and more preferably applied for extreme ultraviolet (EUV) exposure.

The irradiation energy of the electron beam and the exposure amount of light are not particularly limited.

Baking (PEB: post exposure bake) may be performed after light or electron beam irradiation and before development.

The baking temperature is not particularly limited, and is preferably 60°C to 150°C, more preferably 70°C to 120°C, and particularly preferably 75°C to 110°C.

The baking time is not particularly limited, and is preferably 1 second to 10 minutes, more preferably 10 seconds to 5 minutes, and particularly preferably 30 seconds to 3 minutes.

In the development, for example, an alkaline developer is used.

The developing temperature is, for example, 5°C to 50°C.

The developing time is, for example, 10 seconds to 300 seconds.

As the alkaline developer, for example, an aqueous solution of an alkali such as an inorganic alkali (for example, sodium hydroxide, potassium hydroxide, sodium carbonate, sodium silicate, sodium metasilicate, or ammonia water), a primary amine (for example, ethylamine or n-propylamine), a secondary amine (for example, diethylamine or di-n-butylamine), a tertiary amine (for example, triethylamine or methyldiethylamine), an alcoholamine (for example, dimethylethanolamine or triethanolamine), a quaternary ammonium salt (for example, tetramethylammonium hydroxide, tetraethylammonium hydroxide, or choline), or a cyclic amine (for example, pyrrole or piperidine) can be used. Further, an alcohol such as isopropyl alcohol, or a surfactant such as a nonionic surfactant can be added in an appropriate amount to the aqueous solution of an alkali and used. Among these developers, an aqueous solution of a quaternary ammonium salt is preferred, and an aqueous solution of tetramethylammonium hydroxide and an aqueous solution of choline are more preferred. Further, a surfactant or the like can also be added to these developers. It is also possible to use a method in which development is performed with an organic solvent such as butyl acetate in place of the alkaline developer and a portion where the alkali dissolution rate of the photoresist is not improved is developed.

Subsequently, the resist underlayer film is etched using the formed resist pattern as a mask. The etching may be dry etching or wet etching, but is preferably dry etching.

When the inorganic film is formed on the surface of a semiconductor substrate used, the surface of the inorganic film is exposed, and when the inorganic film is not formed on the surface of a semiconductor substrate used, the surface of the semiconductor substrate is exposed. Then, a semiconductor element can be produced through a step of processing the semiconductor substrate with a known method (dry etching method or the like).

### Examples

Hereinafter, the present invention will be more specifically described with reference to examples and comparative examples, but the present invention is not limited to the following examples.

The weight average molecular weights (Mw) of the polymers shown in the following synthesis examples are measurement results by gel permeation chromatography (GPC) method. In the measurement, a GPC apparatus manufactured by TOSOH CORPORATION was used, and measurement conditions are as follows.
· Measuring apparatus: HLC-8020GPC [trade name] (manufactured by TOSOH CORPORATION)
· GPC column: TSKgel G2000HXL x 2, G3000HXL x 1, G4000HXL x 1 [trade name] (all manufactured by TOSOH CORPORATION)
· Column temperature: 40°C
· Solvent: Tetrahydrofuran (THF)
· Flow rate: 1.0 ml/min
· Standard sample: polystyrene (manufactured by TOSOH CORPORATION)

### <Synthesis Example 1> Synthesis of polymer 1

To 40.00 g of propylene glycol monomethyl ether in a reaction vessel, 4.54 g of monoallyl diglycidyl isocyanurate, 5.19 g of 2-iodoisophthalic acid, and 0.27 g of tetrabutylphosphonium bromide were added and dissolved. The reaction vessel was purged with nitrogen, and then a reaction was allowed to proceed by reflux heating for 24 hours to obtain a solution of a polymer 1. GPC analysis was performed, and the polymer 1 in the obtained solution had a weight average molecular weight of 4,700 in terms of standard polystyrene.

The repeating unit of the obtained polymer 1 is shown below. In the drawing, n represents the number of repeating units (the same applies hereinafter).

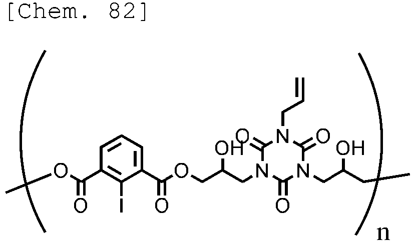

### <Synthesis Example 2> Synthesis of polymer 2

To 40.00 g of propylene glycol monomethyl ether in a reaction vessel, 4.68 g of monoallyl diglycidyl isocyanurate, 4.14 g of 2-iodoisophthalic acid, 0.90 g of adamantane carboxylic acid, and 0.28 g of tetrabutylphosphonium bromide were added and dissolved. The reaction vessel was purged with nitrogen, and then a reaction was allowed to proceed by reflux heating for 24 hours to obtain a solution of a polymer 2. GPC analysis was performed, and the polymer 2 in the obtained solution had a weight average molecular weight of 8,000 in terms of standard polystyrene.

The repeating unit of the obtained polymer 2 is shown below. The following structure also includes a terminal structure.

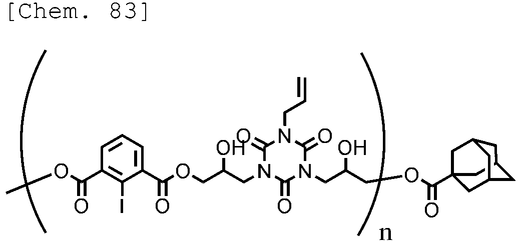

### <Synthesis Example 3> Synthesis of polymer 3

To 40.00 g of propylene glycol monomethyl ether in a reaction vessel, 4.23 g of monoallyl diglycidyl isocyanurate, 3.75 g of 2-iodoisophthalic acid, 1.76 g of 3,5-diiodosalicylic acid, and 0.26 g of tetrabutylphosphonium bromide were added and dissolved. The reaction vessel was purged with nitrogen, and then a reaction was allowed to proceed by reflux heating for 24 hours to obtain a solution of a polymer 3. GPC analysis was performed, and the polymer 3 in the obtained solution had a weight average molecular weight of 7,300 in terms of standard polystyrene.

The repeating unit of the obtained polymer 3 is shown below. The following structure also includes a terminal structure.

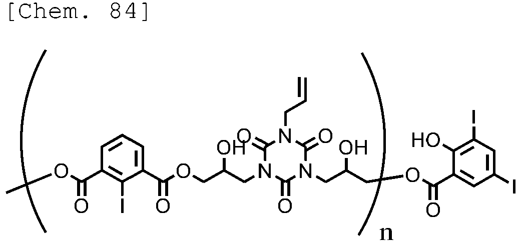

### <Synthesis Example 4> Synthesis of polymer 4

To 40.00 g of propylene glycol monomethyl ether in a reaction vessel, 3.99 g of monomethyl diglycidyl isocyanurate, 5.74 g of 2-iodoisophthalic acid, and 0.28 g of tetrabutylphosphonium bromide were added and dissolved. The reaction vessel was purged with nitrogen, and then a reaction was allowed to proceed by reflux heating for 24 hours to obtain a solution of a polymer 4. GPC analysis was performed, and the polymer 4 in the obtained solution had a weight average molecular weight of 3,500 in terms of standard polystyrene.

The repeating unit of the obtained polymer 4 is shown below.

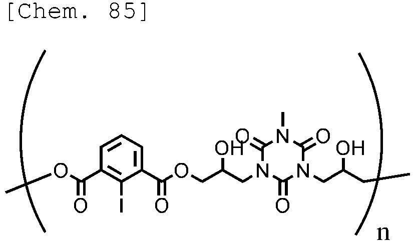

### <Synthesis Example 5> Synthesis of polymer 5

To 40.00 g of propylene glycol monomethyl ether in a reaction vessel, 4.41 g of diglycidyl terephthalate (manufactured by Nagase ChemteX Corporation, trade name: DENACOL [registered trademark] Ex711), 5.33 g of 2-iodoisophthalic acid, and 0.26 g of tetrabutylphosphonium bromide were added and dissolved. The reaction vessel was purged with nitrogen, and then a reaction was allowed to proceed by reflux heating for 24 hours to obtain a solution of a polymer 5. GPC analysis was performed, and the polymer 5 in the obtained solution had a weight average molecular weight of 3,700 in terms of standard polystyrene.

The repeating unit of the obtained polymer 5 is shown below.

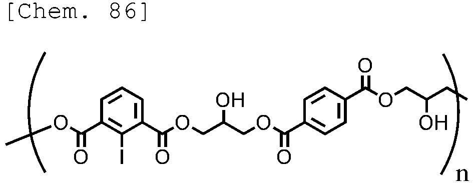

### <Synthesis Example 6> Synthesis of polymer 6

To 40.00 g of cyclohexanone in a reaction vessel, 4.89 g of monoallyl diglycidyl isocyanurate, 4.96 g of 5-iodouracil, and 0.15 g of tetrabutylphosphonium bromide were added and dissolved. The reaction vessel was purged with nitrogen, and then a reaction was allowed to proceed at 120°C for 24 hours to obtain a solution of a polymer 6. GPC analysis was performed, and the polymer 6 in the obtained solution had a weight average molecular weight of 2,300 in terms of standard polystyrene.

The repeating unit of the obtained polymer 6 is shown below.

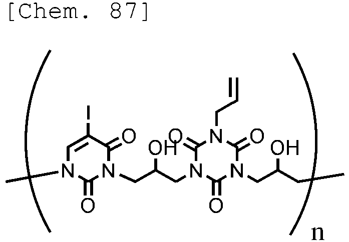

### <Comparative Synthesis Example 1> Synthesis of comparative polymer 1

To 56.00 g of propylene glycol monomethyl ether in a reaction vessel, 8.00 g of monoallyl diglycidyl isocyanurate, 5.45 g of barbital, and 0.48 g of tetrabutylphosphonium bromide were added and dissolved. The reaction vessel was purged with nitrogen, and then a reaction was allowed to proceed by reflux heating for 24 hours to obtain a solution of a comparative polymer 1. GPC analysis was performed, and the comparative polymer 1 in the obtained solution had a weight average molecular weight of 6,800 in terms of standard polystyrene.

The repeating unit of the obtained comparative polymer 1 is shown below.

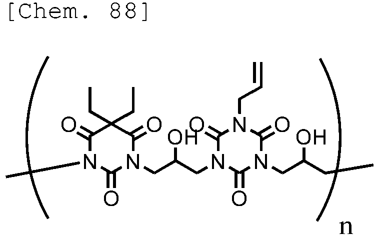

### <Comparative Synthesis Example 2> Synthesis of comparative polymer 2

To 40.00 g of propylene glycol monomethyl ether in a reaction vessel, 5.65 g of monoallyl diglycidyl isocyanurate, 4.07 g of isophthalic acid, and 0.34 g of tetrabutylphosphonium bromide were added and dissolved. The reaction vessel was purged with nitrogen, and then a reaction was allowed to proceed by reflux heating for 24 hours to obtain a solution of a comparative polymer 2. GPC analysis was performed, and the comparative polymer 2 in the obtained solution had a weight average molecular weight of 5,300 in terms of standard polystyrene.

The repeating unit of the obtained comparative polymer 2 is shown below.

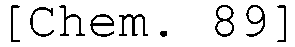

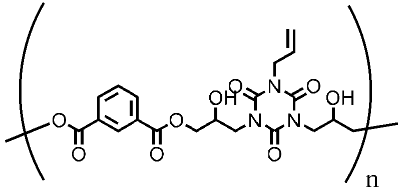

### (Preparation of resist underlayer film-forming composition)

Additives and a solvent were mixed with each of the polymers obtained in the above synthesis examples in the proportions shown in Table 1-1 or 1-2, and the mixture was filtered using a polyethylene microfilter having a pore size of 0.05 µm to prepare each resist underlayer film-forming composition.

In Example 1-1 in Table 1-1, 1.600 parts by mass for the component 1 means 1.600 parts by mass for the polymer 1.

The abbreviations in Tables 1-1 and 1-2 are as follows.
· PL-LI: tetramethoxymethylglycoluril
· PyPTS: pyridinium toluenesulfonic acid
· PGMEA: propylene glycol monomethyl ether acetate
· PGME: propylene glycol monomethyl ether
· CY: cyclohexanone

**[Table 1-1]**

| | | Component 1 | Component 2 | Curing catalyst | Solvent | |
|---|---|---|---|---|---|---|
| Example 1-1 | Type | Polymer 1 | PL-LI | PyPTS | PGME | PGMEA |
| | (parts by mass) | 1.600 | 0.400 | 0.040 | 90 | 10 |
| Example 2-1 | Type | Polymer 2 | PL-LI | PyPTS | PGME | PGMEA |
| | (parts by mass) | 1.600 | 0.400 | 0.040 | 90 | 10 |
| Example 3-1 | Type | Polymer 3 | PL-LI | PyPTS | PGME | PGMEA |
| | (parts by mass) | 1.600 | 0.400 | 0.040 | 90 | 10 |
| Example 4-1 | Type | Polymer 4 | PL-LI | PyPTS | PGME | PGMEA |
| | (parts by mass) | 1.600 | 0.400 | 0.040 | 90 | 10 |
| Example 5-1 | Type | Polymer 5 | PL-LI | PyPTS | PGME | PGMEA |
| | (parts by mass) | 1.600 | 0.400 | 0.040 | 90 | 10 |
| Example 6-1 | Type | Polymer 6 | PL-LI | PyPTS | PGME | CY |
| | (parts by mass) | 1.920 | 0.480 | 0.048 | 30 | 70 |
| Comparative Example 1-1 | Type | Comparative Polymer 1 | PL-LI | PyPTS | PGME | PGMEA |
| | (parts by mass) | 1.682 | 0.421 | 0.042 | 70 | 30 |
| Comparative Example 2-1 | Type | Comparative Polymer 2 | PL-LI | PyPTS | PGME | PGMEA |
| | (parts by mass) | 1.600 | 0.400 | 0.040 | 90 | 10 |

**[Table 1-2]**

| | | Component 1 | Component 2 | Curing catalyst | Solvent | |
|---|---|---|---|---|---|---|
| Example 1-2 | Type | Polymer 1 | PL-LI | PyPTS | PGME | PGMEA |
| | (parts by mass) | 0.145 | 0.036 | 0.004 | 90 | 10 |
| Example 2-2 | Type | Polymer 2 | PL-LI | PyPTS | PGME | PGMEA |
| | (parts by mass) | 0.145 | 0.036 | 0.004 | 90 | 10 |
| Example 3-2 | Type | Polymer 3 | PL-LI | PyPTS | PGME | PGMEA |
| | (parts by mass) | 0.145 | 0.036 | 0.004 | 90 | 10 |
| Example 4-2 | Type | Polymer 4 | PL-LI | PyPTS | PGME | PGMEA |
| | (parts by mass) | 0.145 | 0.036 | 0.004 | 90 | 10 |
| Example 5-2 | Type | Polymer 5 | PL-LI | PyPTS | PGME | PGMEA |
| | (parts by mass) | 0.145 | 0.036 | 0.004 | 90 | 10 |
| Example 6-2 | Type | Polymer 6 | PL-LI | PyPTS | PGME | CY |
| | (parts by mass) | 0.173 | 0.043 | 0.004 | 30 | 70 |
| Comparative Example 1-2 | Type | Comparative Polymer 1 | PL-LI | PyPTS | PGME | PGMEA |
| | (parts by mass) | 0.157 | 0.039 | 0.004 | 70 | 30 |
| Comparative Example 2-2 | Type | Comparative Polymer 2 | PL-LI | PyPTS | PGME | PGMEA |
| | (parts by mass) | 0.145 | 0.036 | 0.004 | 90 | 10 |

### (Measurement of dry etching rate)

The following etcher and etching gas were used for the measurement of the dry etching rate.
· RIE-10NR (manufactured by Samco): CF₄

Each of the resist underlayer film-forming compositions of Examples 1-1 to 6-1 and Comparative Examples 1-1 to 2-1 was applied onto a silicon wafer using a spinner. The silicon wafers were baked on a hot plate at 215°C for 60 seconds to form resist underlayer films (film thickness: 500 nm). The film thickness was measured using an ellipsometric film thickness measurement system RE-3100 (SCREEN Semiconductor Solutions Co., Ltd.).

With respect to these resist underlayer films, a dry etching rate was measured using CF₄ gas as an etching gas. The etching rate ratio when the etching rate of the resist underlayer film of Comparative Example 1-1 is taken as 1.0 is shown in Table 2.

**[Table 2]**

| | Etching rate ratio |
|---|---|
| Example 1-1 | 1.2 |
| Example 2-1 | 1.1 |
| Example 3-1 | 1.3 |
| Example 4-1 | 1.3 |
| Example 5-1 | 1.1 |
| Example 6-1 | 1.3 |
| Comparative Example 1-1 | 1.0 |
| Comparative Example 2-1 | 0.9 |

### (Evaluation of resist patterning)

### <Test for resist pattern formation by electron beam lithography apparatus>

Each of the resist underlayer film-forming compositions of Examples 1-2 to 6-2 and Comparative Examples 1-2 to 2-2 was applied onto a silicon wafer using a spinner. The silicon wafers were baked on a hot plate at 215°C for 60 seconds to form resist underlayer films (film thickness: 500 nm).

An EUV positive resist solution was applied by spin coating onto each of the resist underlayer films formed on the silicon wafers, and heated at 130°C for 60 seconds to form an EUV resist film having a film thickness of 35 nm. The resist film was exposed under predetermined conditions using an electron beam lithography apparatus (ELS-G130). After the exposure, the silicon wafer was baked (PEB) at 90°C for 60 seconds, cooled on a cooling plate to room temperature, and subjected to puddle developing for 30 seconds using a 2.38% aqueous tetramethylammonium hydroxide solution (trade name: NMD-3 manufactured by Tokyo Ohka Kogyo Co., Ltd.) as a photoresist developer. A resist pattern having a line size of 16 nm to 28 nm was formed. A scanning electron microscope (CG4100 manufactured by Hitachi High-Technologies Corporation) was used to measure the length of the resist pattern.

The photoresist pattern thus obtained was observed from the upper part of the pattern. The amount of charge for forming 22 nm line/44 nm pitch (line-and-space (L/S = 1/1)) was defined as the optimum irradiation energy, and the irradiation energy (µC/cm²) at that time and a line width roughness (LWR) which is a value indicating the roughness of the pattern shape were checked. The LWR indicates a triple value (3σ) (unit: nm) of a standard deviation (σ) obtained from the measurement results at 400 line positions in the longitudinal direction of the line with a scanning electron microscope (CG4100, manufactured by Hitachi High-Tech Corporation). A smaller value of LWR indicates that a pattern capable of forming a favorable pattern is formed. The results are shown in Table 3.

**[Table 3]**

| | Irradiation energy (µC/cm²) | LWR (nm) |
|---|---|---|
| Example 1-2 | 610 | 4.0 |
| Example 2-2 | 613 | 3.9 |
| Example 3-2 | 626 | 3.9 |
| Example 4-2 | 628 | 4.1 |
| Example 5-2 | 636 | 4.1 |
| Example 6-2 | 636 | 4.2 |
| Comparative Example 1-2 | 635 | 4.2 |
| Comparative Example 2-2 | 616 | 4.0 |

From Table 2, in Examples 1-1 to 6-1, an improvement in the etching rate was observed as compared with Comparative Examples 1-1 and 2-1, and from Table 3, in Examples 1-2 to 6-2, equivalent lithographic properties were shown as compared with Comparative Examples 1-2 and 2-2. Thus, the resist underlayer film-forming compositions using the polymers 1 to 6 can increase the etching rate while maintaining the lithographic properties.

## Claims

1. A resist underlayer film-forming composition, comprising a polymer (A) having a repeating unit represented by formula (1) below and a solvent (B): 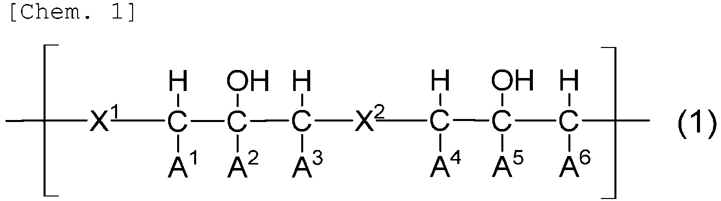
in formula (1), X¹ represents a divalent group having a ring structure and an iodine atom directly bonded to the ring structure,
X² represents a divalent group, and
A¹, A², A³, A⁴, A⁵, and A⁶ each independently represent a hydrogen atom, a methyl group, or an ethyl group.

2. The resist underlayer film-forming composition according to claim 1, wherein X¹ in formula (1) represents any of a group represented by formula (2-1) below, a group represented by formula (2-2) below, and a group represented by formula (2-3) below: 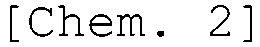 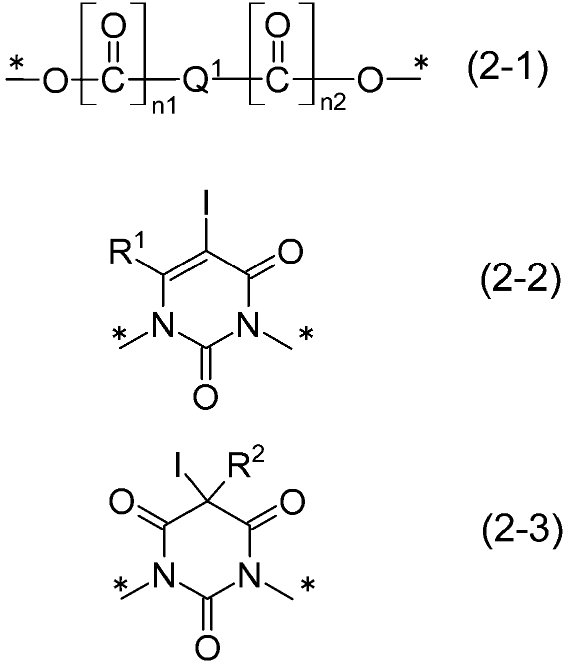
in formula (2-1), Q¹ represents a divalent organic group represented by formula (2-1-1) below, a divalent organic group represented by formula (2-1-2) below, a divalent organic group represented by formula (2-1-3) below, or a divalent organic group represented by formula (2-1-4) below, n1 and n2 each independently represent 0 or 1, and * represents a bond,
in formula (2-2), R¹ represents a hydrogen atom, a halogen atom, or an organic group having 1 to 10 carbon atoms, and * represents a bond,
in formula (2-3), R² represents a hydrogen atom, a halogen atom, or an organic group having 1 to 10 carbon atoms, and * represents a bond: 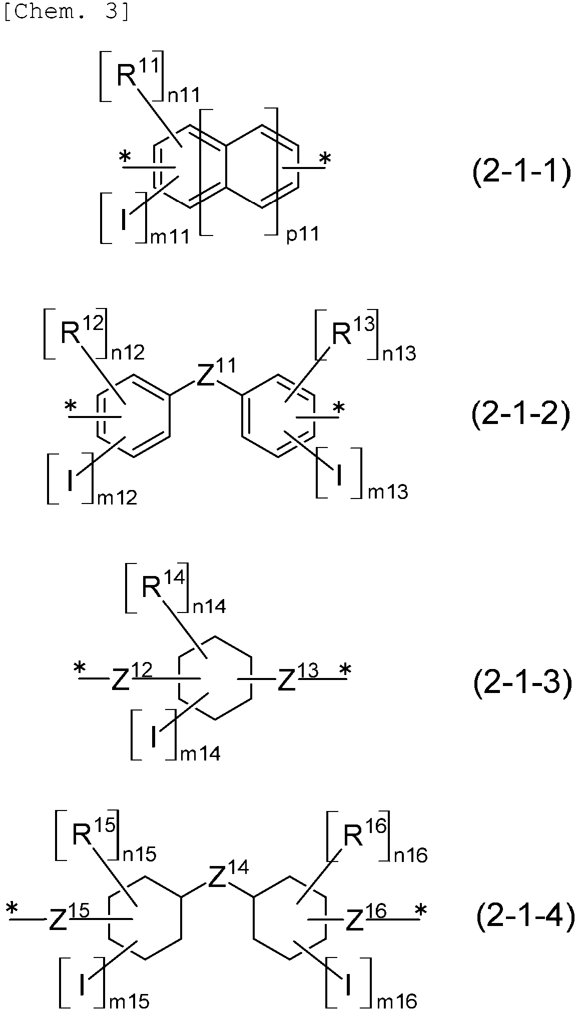
in formulae (2-1-1) to (2-1-4), R¹¹ to R¹⁶ each independently represent a halogen atom (exclusive of an iodine atom), a hydroxy group, a cyano group, an alkyl group having 1 to 6 carbon atoms, an alkenyl group having 2 to 6 carbon atoms, an alkynyl group having 2 to 6 carbon atoms, an alkoxy group having 1 to 6 carbon atoms, an alkenyloxy group having 2 to 6 carbon atoms, an alkynyloxy group having 2 to 6 carbon atoms, an acyl group having 2 to 6 carbon atoms, an aryloxy group having 6 to 12 carbon atoms, an arylcarbonyl group having 7 to 13 carbon atoms, an aralkyl group having 7 to 13 carbon atoms, or -N(R^{a}) (R^{b}) (R^{a} and R^{b} each independently represent a hydrogen atom or an alkyl group having 1 to 6 carbon atoms), and * represents a bond,
in formula (2-1-1), p11 represents an integer of 0 to 2, when p11 is 0, m11 represents an integer of 1 to 4, n11 represents an integer of 0 to 3, and a sum of m11 and n11 is 4 or less, when p11 is 1, m11 represents an integer of 1 to 6, n11 represents an integer of 0 to 5, and a sum of m11 and n11 is 6 or less, when p11 is 2, m11 represents an integer of 1 to 8, n11 represents an integer of 0 to 7, and a sum of m11 and n11 is 8 or less, and when two or more R¹¹'s are present, the two or more R¹¹'s may be identical or different,
in formula (2-1-2), Z¹¹ represents a single bond, an oxygen atom, a sulfur atom, a carbonyl group, a sulfonyl group, or an alkylene group having 1 to 6 carbon atoms, m12 and m13 each independently represent an integer of 0 to 4, n12 and n13 each independently represent an integer of 0 to 4, a sum of m12 and m13 is 1 or more, a sum of m12 and n12 is 4 or less, and a sum of m13 and n13 is 4 or less, when two or more R¹²'s are present, the two or more R¹²'s may be identical or different, and when two or more R¹³'s are present, the two or more R¹³'s may be identical or different,
in formula (2-1-3), Z¹² and Z¹³ each independently represent a single bond or a linear or branched alkylene group having 1 to 6 carbon atoms, m14 represents an integer of 1 to 4, n14 represents an integer of 0 to 3, and a sum of m14 and n14 is 4 or less, and when two or more R¹⁴'s are present, the two or more R¹⁴'s may be identical or different,
in formula (2-1-4), Z¹⁴ represents a single bond, an oxygen atom, a sulfur atom, a carbonyl group, a sulfonyl group, or an alkylene group having 1 to 6 carbon atoms, Z¹⁵ and Z¹⁶ each independently represent a single bond or a linear or branched alkylene group having 1 to 6 carbon atoms, m15 and m16 each independently represent an integer of 0 to 4, n15 and n16 each independently represent an integer of 0 to 4, a sum of m15 and m16 is 1 or more, a sum of m15 and n15 is 4 or less, and a sum of m16 and n16 is 4 or less, when two or more R¹⁵'s are present, the two or more R¹⁵'s may be identical or different, and when two or more R¹⁶'s are present, the two or more R¹⁶'s may be identical or different.

3. The resist underlayer film-forming composition according to claim 1, wherein X² in formula (1) represents either a group represented by formula (3-1) below or a group represented by formula (3-2) below: 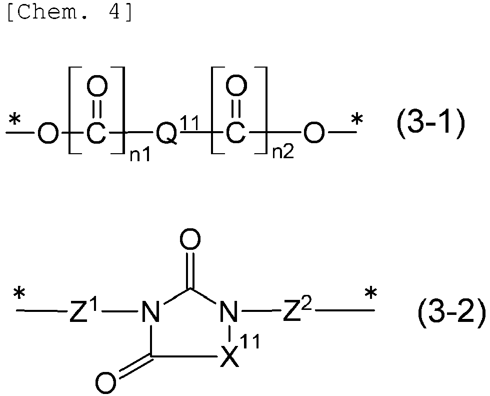
in formula (3-1), Q¹¹ represents a divalent acyclic hydrocarbon group having 2 to 20 carbon atoms which may be interrupted by an oxygen atom, a divalent organic group represented by formula (3-1-1) below, a divalent organic group represented by formula (3-1-2) below, a divalent organic group represented by formula (3-1-3) below, or a divalent organic group represented by formula (3-1-4) below, n1 and n2 each independently represent 0 or 1, and * represents a bond,
in formula (3-2), X¹¹ represents a divalent group represented by any of formulae (3-2-1) to (3-2-3), Z¹ and Z² each independently represent a single bond or a divalent group represented by formula (2-2-4) below, and * represents a bond: 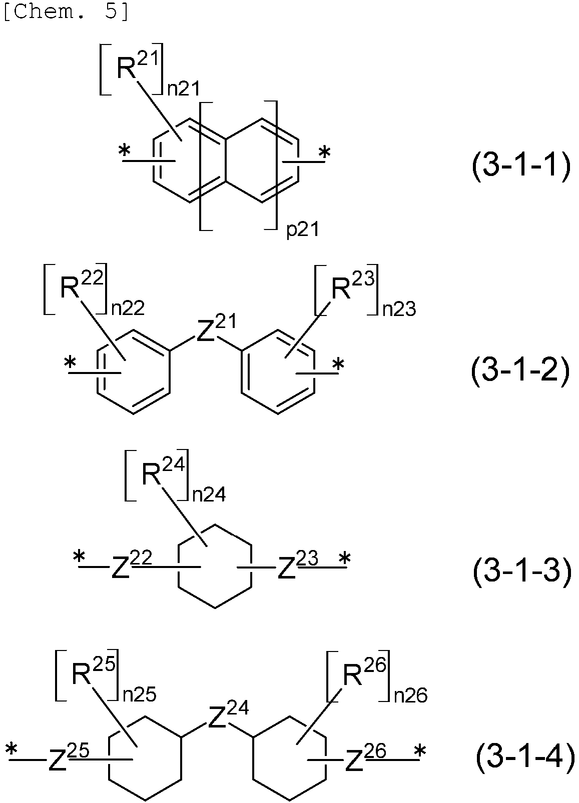
in formulae (3-1-1) to (3-1-4), R²¹ to R²⁶ each independently represent a halogen atom, a hydroxy group, a cyano group, an alkyl group having 1 to 6 carbon atoms, an alkenyl group having 2 to 6 carbon atoms, an alkynyl group having 2 to 6 carbon atoms, an alkoxy group having 1 to 6 carbon atoms, an alkenyloxy group having 2 to 6 carbon atoms, an alkynyloxy group having 2 to 6 carbon atoms, an acyl group having 2 to 6 carbon atoms, an aryloxy group having 6 to 12 carbon atoms, an arylcarbonyl group having 7 to 13 carbon atoms, or an aralkyl group having 7 to 13 carbon atoms, and * represents a bond,
in formula (3-1-1), p21 represents an integer of 0 to 2, when p21 is 0, n21 represents an integer of 0 to 4, when p21 is 1, n21 represents an integer of 0 to 6, when p21 is 2, n21 represents an integer of 0 to 8, and when two or more R²¹'s are present, the two or more R²¹'s may be identical or different,
in formula (3-1-2), Z²¹ represents a single bond, an oxygen atom, a sulfur atom, a carbonyl group, a sulfonyl group, or an alkylene group having 1 to 6 carbon atoms, n22 and n23 each independently represent an integer of 0 to 4, when two or more R²²'s are present, the two or more R²²'s may be identical or different, and when two or more R²³'s are present, the two or more R²³'s may be identical or different,
in formula (3-1-3), Z²² and Z²³ each independently represent a single bond or a linear or branched alkylene group having 1 to 6 carbon atoms, n24 represents an integer of 0 to 4, and when two or more R²⁴'s are present, the two or more R²⁴'s may be identical or different,
in formula (3-1-4), Z²⁴ represents a single bond, an oxygen atom, a sulfur atom, a carbonyl group, a sulfonyl group, or an alkylene group having 1 to 6 carbon atoms, Z²⁵ and Z²⁶ each independently represent a single bond or a linear or branched alkylene group having 1 to 6 carbon atoms, n25 and n26 each independently represent an integer of 0 to 4, when two or more R²⁵'s are present, the two or more R²⁵'s may be identical or different, and when two or more R²⁶'s are present, the two or more R²⁶'s may be identical or different: 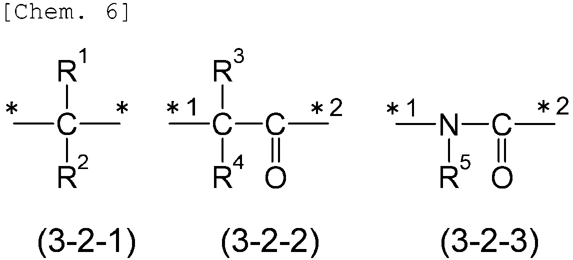
in formulae (3-2-1) to (3-2-3), R¹ to R⁵ each independently represent a hydrogen atom, an alkyl group having 1 to 10 carbon atoms which may be interrupted by an oxygen atom or a sulfur atom, an alkenyl group having 2 to 10 carbon atoms which may be interrupted by an oxygen atom or a sulfur atom, an alkynyl group having 2 to 10 carbon atoms which may be interrupted by an oxygen atom or a sulfur atom, a benzyl group, or a phenyl group, wherein the phenyl group may be substituted with at least one monovalent group selected from a group consisting of an alkyl group having 1 to 6 carbon atoms, a halogen atom, an alkoxy group having 1 to 6 carbon atoms, a nitro group, a cyano group, and an alkylthio group having 1 to 6 carbon atoms, R¹ and R² may be bonded to each other to form a ring having 3 to 6 carbon atoms, and R³ and R⁴ may be bonded to each other to form a ring having 3 to 6 carbon atoms,
* represents a bond, *1 represents a bond bonded to a carbon atom in formula (3-2), and *2 represents a bond bonded to a nitrogen atom in formula (3-2): 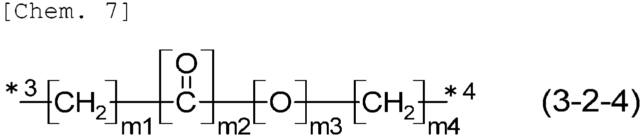
in formula (3-2-4), m1 is an integer of 0 to 4, m2 is 0 or 1, m3 is 0 or 1, and m4 is an integer of 0 to 2, provided that, when m3 is 1, m1 and m2 are not both 0 at the same time, *3 represents a bond bonded to a nitrogen atom in formula (3-2), and *4 represents a bond.

4. The resist underlayer film-forming composition according to claim 1, wherein the solvent (B) contains at least one type selected from a group consisting of an alkylene glycol monoalkyl ether and a monocarboxylic acid ester of an alkylene glycol monoalkyl ether.

5. The resist underlayer film-forming composition according to claim 1, further comprising a crosslinking agent (C).

6. The resist underlayer film-forming composition according to claim 1, further comprising a curing catalyst (D).

7. A resist underlayer film, which is a cured product of the resist underlayer film-forming composition according to any one of claims 1 to 6.

8. A laminate, comprising:
a semiconductor substrate; and
the resist underlayer film according to claim 7.

9. A semiconductor element producing method, comprising steps of:
forming a resist underlayer film on a semiconductor substrate using the resist underlayer film-forming composition according to any one of claims 1 to 6; and
forming a resist film on the resist underlayer film.

10. A pattern forming method, comprising steps of:
forming a resist underlayer film on a semiconductor substrate using the resist underlayer film-forming composition according to any one of claims 1 to 6;
forming a resist film on the resist underlayer film;
irradiating the resist film with light or an electron beam, and then developing the resist film to obtain a resist pattern; and
etching the resist underlayer film using the resist pattern as a mask.
